# EUROPEAN PATENT SPECIFICATION

(11) **EP 3 007 161 B1**
(45) Date of publication and mention of the grant of the patent: **05.12.2018**
(21) Application number: 15173372.2
(22) Date of filing: 23.06.2015
(51) Int. Cl.: G09G 3/32, H01L 27/32

(54) **ORGANIC LIGHT EMITTING DISPLAY DEVICE AND TRANSISTOR STRUCTURE FOR THE SAME**
Organische lichtemittierende Anzeigevorrichtung und Transistorstruktur dafür
Dispositif d'affichage électroluminescent organique et sa structure de transistor

(30) Priority: 06.10.2014 KR 20140134069
(43) Date of publication of application: 13.04.2016
(73) Proprietor: LG Display Co., Ltd., Seoul 150-721 (KR)
(72) Inventor: PARK, Joon-Min, 151-712 Seoul (KR)
(74) Representative: Viering, Jentschura & Partner mbB Patent- und Rechtsanwälte

(56) References cited:
- EP-A1- 2 874 141
- EP-A1- 2 889 861
- US-A1- 2013 050 292
- US-A1- 2014 022 289
- US-A1- 2014 092 076
- US-A1- 2014 285 407

## Description

### CROSS-REFERENCE TO RELATED APPLICATION

This application claims priority from and the benefit of Korean Patent Application No. 10-2014-0134069, filed on October 6, 2014.

### BACKGROUND OF THE INVENTION

### 1. Field of the invention

The present invention relates to an organic light emitting display device that displays an image.

### 2. Description of the Prior Art

Recently, an organic light emitting display device, spotlighted as a display device, uses self-luminous Organic Light Emitting Diodes (OLED) and thus, is advantageous in that it has a fast response speed, high light emitting efficiency, high luminance, and a wide viewing angle.

The organic light emitting display device includes pixels, which are provided with organic light emitting diodes and arranged in a matrix form, and controls brightness of the pixels selected by a scan signal according to a gradation of data.

Each pixel of the organic light emitting display device includes, for example, a data line and a gate line, which intersect with each other, a transistor and a storage capacitor which have a connection structure with the data line and the gate line, in addition to an organic light emitting diode.

In order to execute various functions, each pixel may further include transistors suitable for the functions. Due to this, it is inevitable that a number of signal lines for supplying various signals to the transistors increases and pixel structures become more complicated. For example, when an inner or outer compensation circuit for compensating for nonuniformity of luminance among the pixels is applied to a pixel structure, a transistor involved in a sensing operation for compensation should be added which causes the number of required signal lines to increase and the pixel structure to be complicated.

As demand for a large area or high resolution increases, it is inevitable that the number of signal lines increases accordingly, and in practice, the pixel structures become further complicated.

As described above, due to, for example, the addition of various functions such as a sensing function and a compensation function, and increase of demand for a large area or high resolution, the number of signal lines increase, and as a result, it is inevitable that the number of IC pads and the number of ICs increases accordingly and the pixel structures become further complicated.

This may make manufacturing difficult, increase the incidence probability of pixel defects, remarkably degrade a numerical aperture, and considerably shorten the lifespan of the organic light emitting diodes. Consequently, it becomes difficult or impossible to obtain a high quality display panel, thereby reducing yield.

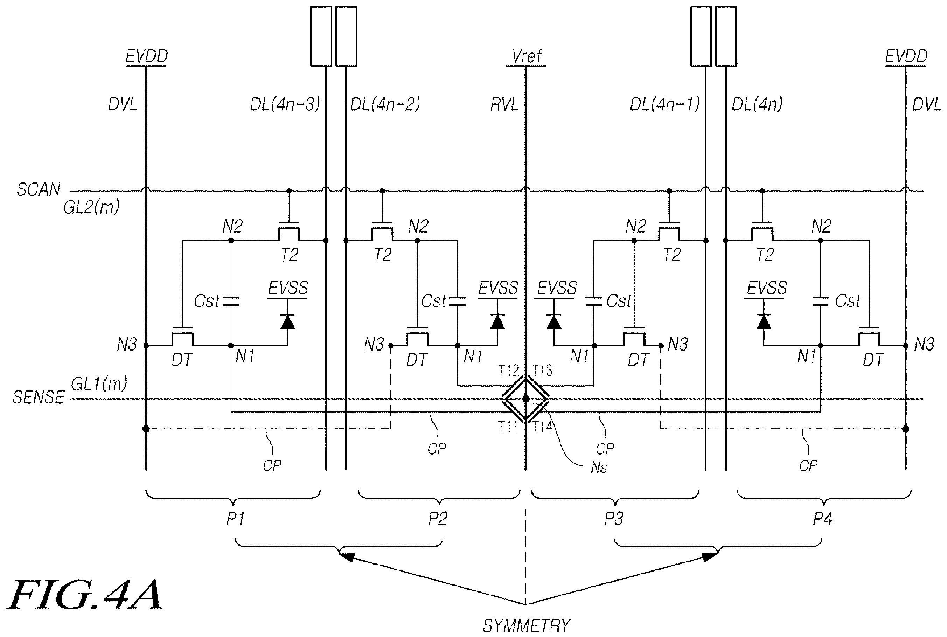

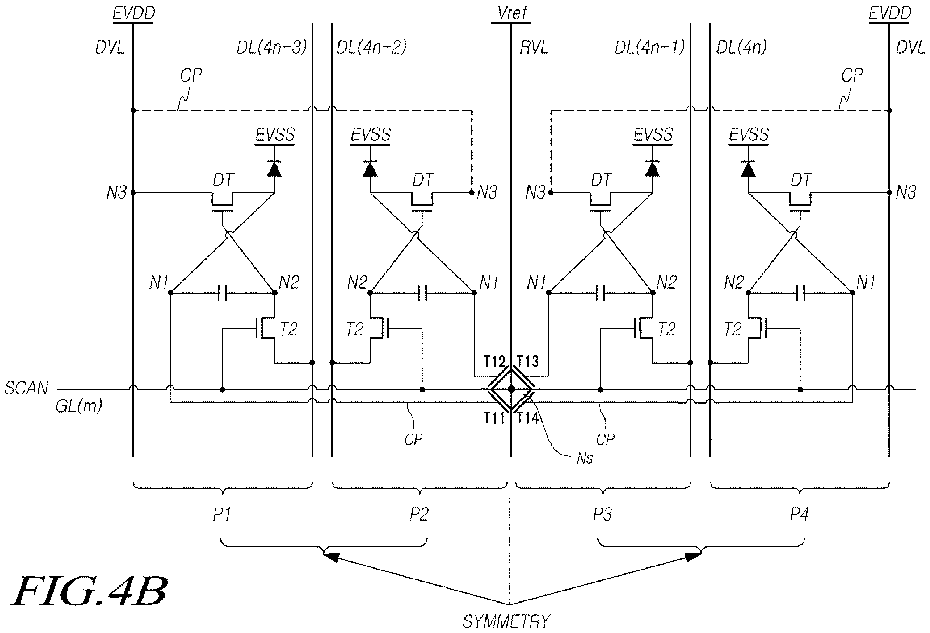

EP 2 874 141 A1 (published after the priority date claimed by the present application) is entitled *"Organic light-emitting display device and driving method thereof".* According to Figure 4 of the document, two transistors (T1, T1) of two central OLED pixels (adjacent to a reference voltage line RVL) have nodes integrally formed with the reference voltage line (RVL) at its intersection with a gate line (GL1). The other nodes of those two transistors (T1, T1) are individual nodes connected to respective driving transistors DT of the two central pixels. Connection patterns CP (not integral with the reference voltage line RVL) are used to connect the reference voltage line RVL to nodes of two transistors (T1, T1) in two other pixels that are more distant from the reference voltage line (paragraphs 0057...0065).

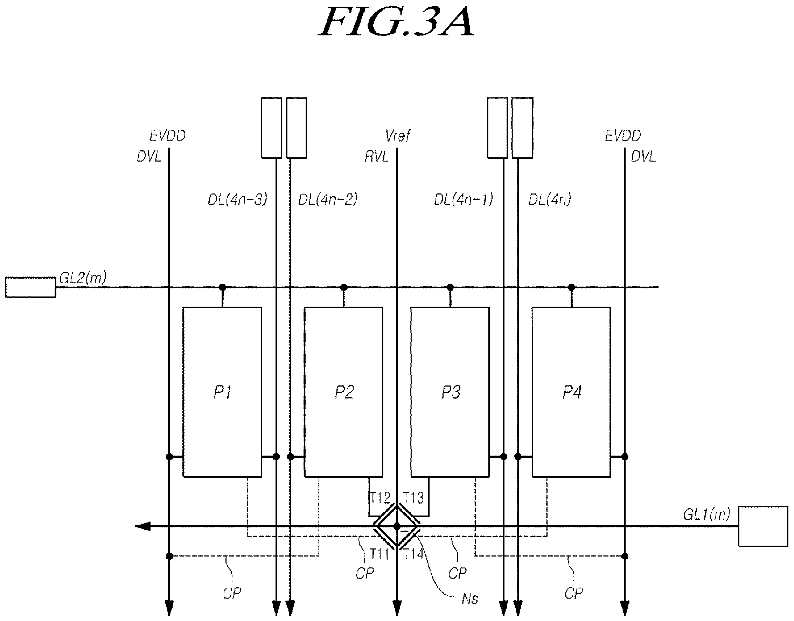

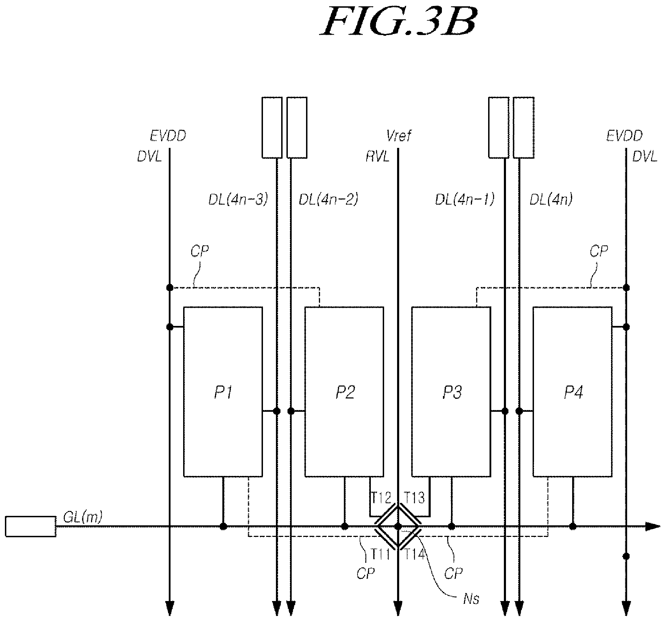

EP 2 889 861 A1 (published after the filing date of the present application) is entitled *"Organic light emitting display device wherein driving characteristic values are sensed by a reference line in common to neighboring pixels".* Figure 3 of the document schematically suggests a kind of shared node used at a reference voltage line RLk: Two transistors (Tsw2, Tsw2) of two pixels neighboring the reference voltage line (RLk) are connected "in common" to the reference voltage line (paragraphs 0025, 0060, 0114). The other electrodes of those transistors (Tsw2, Tsw2) are individual nodes connected to respective driving transistors Tdr in those pixels (paragraphs 0028, 0032).

US 2014/0092076 A1 is entitled *"Organic light-emitting diode display device".* Figure 5A shows two transistors SW-T2 having individual nodes respectively connected to driving transistors DR-T of two neighboring pixels (PX1, PX2).

US 2014/0285407 A1) is entitled *"System and methods for extraction of threshold and mobility parameters in AMOLED displays".* According to that document, a driver circuit for an OLED pixel should comprise *"as few components as possible to maximize pixel aperture"* (paragraph 0007). To this end, *"two or more pixels"* may *"share the same monitor lines"* (paragraph 0335) .

US 2013/0050292 A1 is entitled *"Organic light emitting diode display device for pixel current sensing and pixel current sensing method thereof"* and concerns a compensator operating on the basis of a sensed voltage to compensate for differences between, and degradations of, characteristics of driving TFTs.

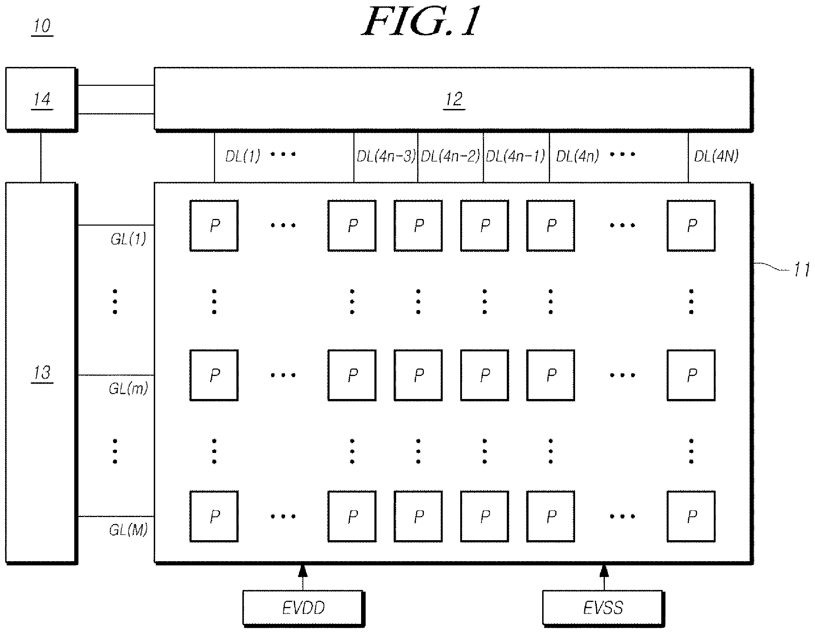

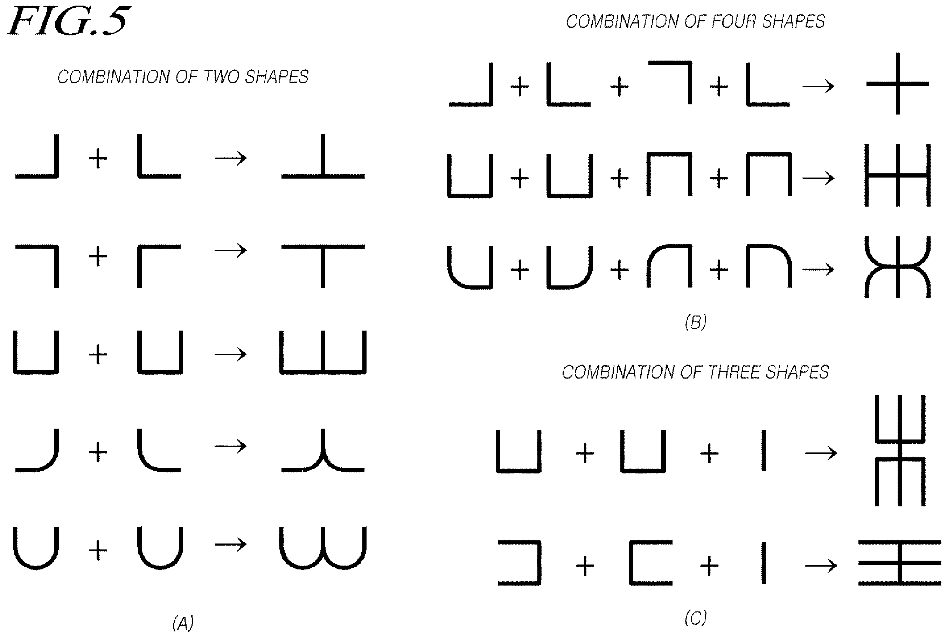

US 2014/0022289 A1 entitled *"Organic light emitting diode display device for sensing pixel current and pixel current sensing method thereof"* mentions nodes (N1, N2) as reference points in schematic circuit diagrams (Figures 1, 5, 9). Figure 5 uses two reference voltage lines (RLm1, RLm2), with each reference voltage line connected to one pair of switching TFTs (ST2). Circuit structures of two pixels may be symmetrical with respect to a reference line (RLm; RLml; RLm2) (paragraphs 0050, 0091).

### SUMMARY OF THE INVENTION

In consideration of the problems described above, an object of the present invention is to provide a display panel having a simple and compact structure and an organic light emitting display device including the display panel.

Another object of the present invention is to provide a display panel having a pixel structure capable of at least one (e.g., all) of increasing a numerical aperture, lengthening the lifespan of a light emitting diode, and reducing the incident probability of defects, and an organic light emitting display device including the display panel.

Still another object of the present invention is to provide an organic light emitting display device having sensing and compensation functions suitable for a simple and compact pixel structure in providing efficient sensing and compensation functions for compensating for a luminance deviation among pixels.

In order to achieve one or more (e.g., all) of the above-described objects, in one aspect, the present invention provides an organic light emitting display device comprising the features of claim 1.

The first nodes may be source nodes and the second nodes may be drain nodes of the respective first transistors. Alternatively, the first nodes may be drain nodes and the second nodes may be source nodes of the respective first transistors.

The organic light emitting display device comprises a semiconductor layer positioned between the shared node and the four individual nodes, wherein the semiconductor layer is one common layer between the shared node and the four individual nodes.

In one or more embodiments, the individual node of the first transistor included in the first pixel is connected through a connection pattern with the first node of the driving transistor included in the first pixel; the individual node of the first transistor included in the second pixel is connected directly with the first node of the driving transistor included in the second pixel; the individual node of the first transistor included in the third pixel is connected directly with the first node of the driving transistor included in the third pixel, and the individual node of the first transistor included in the fourth pixel is connected through a connection pattern with the first node of the driving transistor included in the fourth pixel.

In one or more embodiments, the shared node has a shape obtained by combining two or more of a "l" shape, a "-" shape, a "¬" shape, a "L" shape, a "⊏" shape, and partially rounded shapes thereof.

In one or more embodiments, the shared node has a "+" shape, a "⊥" shape, a " 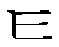 " shape, or a " 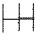 " shape.

In one or more embodiments, a distance between the shared node and the individual node of at least one of the four first transistors is different from that of another one of the four first transistors.

In one or more embodiments, a pixel structure of the first pixel and a pixel structure of the fourth pixel are symmetric to each other with respect to the reference voltage line, and a pixel structure of the second pixel and a pixel structure of the third pixel are symmetric to each other with respect to the reference voltage line.

In one or more embodiments, the organic light emitting display device further comprises a display panel which comprises: a data driver configured to drive the plurality of data lines positioned in the one direction; a gate driver configured to supply a first scan signal and a second signal the plurality of gate lines which are positioned in the other direction intersecting with the data lines; and a timing controller configured to control a driving timing of the data driver and the gate driver.

In one or more embodiments, the organic light emitting display device further comprises: a sensor configured to sense a voltage of the first node of the driving transistor.

In one or more embodiments, the sensor comprises: an analog-to-digital converter configured to convert the sensed voltage into a digital value; and a first switch configured to perform switching such that one of a reference voltage supply node, to which a reference voltage is supplied, and a sensing node connected to the analog digital converter is connected with the reference voltage line.

In one or more embodiments, a plurality of sensors are provided, the number of the sensors corresponding to the number of the data lines or the number of the reference voltage lines.

In one or more embodiments, the timing controller (14) controls switching operations of: a first switch configured to perform switching between an ON position, in which the reference voltage line is connected with the reference voltage supply node, and an OFF position, in which the reference voltage line is connected with the sensing node, and a second switch configured to perform switching between an ON position, in which a data voltage output point of the data driver is connected with a corresponding data line, and an OFF position, in which the data line is disconnected from the voltage output point and floating.

In one or more embodiments, the organic light emitting display device further comprises: a compensator configured to perform data conversion processing that compensates characteristic information of the driving transistor (DT) based on the sensed voltage; and a memory configured to store the sensed voltage or the characteristic information of the driving transistor.

In one or more embodiments, the compensator is included within the timing controller, within the data driver, or outside of the timing controller and the data driver.

In one or more embodiments, if the compensator is included within the timing controller, the compensator converts data supplied from the outside into compensation data based on the characteristic information of the driving transistor, and supplies the compensation data to the data driver, if the compensator is included within the data driver, the compensator converts data supplied from the timing controller into the compensation data based on the characteristic information of the driving transistor, before or after converting the data supplied from the timing controller into analog data, and if the compensator is included outside of the timing controller and the data driver, the compensator converts the data supplied from the timing controller into the compensation data based on the characteristic information of the driving transistor and supplies the compensation data to the data driver.

An organic light emitting display device includes: a plurality of data lines positioned in one direction; a plurality of gate lines positioned in another direction intersecting with the plurality of data lines; and a plurality of pixels connected with the plurality of data lines and the plurality of gate lines.

A display panel may include: a data driver configured to drive a plurality of data lines positioned in one direction; a gate driver configured to supply a first scan signal and a second signal through a plurality of gate lines which are positioned in another direction intersecting with the data lines; a timing controller configured to control a driving timing of the data driver and the gate driver; and a plurality of pixels connected with the data lines and the gate lines.

Each of the plurality of pixels includes: an organic light emitting diode, a driving transistor configured to drive the organic light emitting diode, a first transistor controlled by a first scan signal from the gate lines and connected between one of the reference voltage lines and a first node of the driving transistor, and a second transistor controlled by a second scan signal supplied from the gate lines and connected between the data lines and a second node of the driving transistor.

Each reference voltage line is positioned in the one direction and configured to supply a reference voltage to a first pixel connected with a (4n-3)^{th} data line, a second pixel connected with a (4n-2)^{th} data line, a third pixel connected with a (4n-1)^{th} data line, and a fourth pixel connected with a (4n)^{th} data line, wherein n is a natural number of 1 or more. The first to fourth pixels are positioned adjacent to each other along the other direction. Each first transistor has a first node of one of drain and source electrode of the first transistor and a second node of the other of drain and source electrode of the first transistor, wherein the first nodes of the first transistors of the first to fourth pixels are configured as a shared node formed integrally with the reference voltage line, and the second nodes of the first transistors of said first to fourth pixels are configured as individual nodes, and each of said individual nodes is connected with the first node of the driving transistor of the respective pixel directly or through a connection pattern.

As described above, according to the present invention, it is possible to provide a display panel having a simple and compact structure and an organic light emitting display device including the display panel.

In addition, according to the present invention, it is possible to provide a display panel having a pixel structure capable of at least one (e.g., all) of increasing a numerical aperture, lengthening the lifespan of a light emitting diode, and reducing the incident probability of defects, and an organic light emitting display device including the display panel.

Further, according to the present invention, it is possible to provide an organic light emitting display device having sensing and compensation functions suitable for a simple and compact pixel structure in providing efficient sensing and compensation functions for compensating for a luminance deviation among pixels.

Due to the features described above, a high quality display panel may be manufactured with a high yield.

The features described above are capable of exhibiting a larger effect when they are applied to a display panel having a high resolution and a large area.

### BRIEF DESCRIPTION OF THE DRAWINGS

The above and other objects, features and advantages of the present invention will be more apparent from the following detailed description taken in conjunction with the accompanying drawings, in which:
FIG. 1 is a diagram illustrating a configuration of an entire system for an organic light emitting display device according to embodiments of the present invention;
FIG. 2A is an equivalent circuit diagram for one pixel within a display panel of an organic light emitting display device according to one embodiment of the present invention;
FIG. 2B is an equivalent circuit diagram for one pixel within a display panel of an organic light emitting display device according to another embodiment of the present invention;
FIG. 3A is a plan view briefly illustrating a part of a display panel of an organic light emitting display device according to one embodiment of the present invention;
FIG. 3B is a plan view briefly illustrating a part of a display panel of an organic light emitting display device according to another embodiment of the present invention;
FIG. 4A is an equivalent circuit diagram, in which the equivalent circuit diagram for one pixel illustrated in FIG. 3A is applied to four pixels;
FIG. 4B is an equivalent circuit diagram, in which the equivalent circuit diagram for one pixel illustrated in FIG. 3B is applied to four pixels;
FIG. 5 illustrates various examples that configure a shape of a shared node of first transistors;
FIGS. 6A to 6G illustrate cases in which a shared node (Ns) has a "+" shape, a " 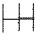 " shape, a "⊥" shape, or a " 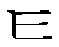 " shape, by way of examples;
FIG. 7 is a diagram briefly illustrating an external compensation configuration included in an organic light emitting display device according to embodiments of the present invention;
FIG. 8 is a diagram illustrating a method of implementing an external compensation configuration included in an organic light emitting display device according to embodiments of the present invention;
FIG. 9A is a diagram illustrating an external compensation configuration of an organic light emitting display device according to one embodiment of the present invention together with an equivalent circuit for one pixel, with respect to the implementing method of FIG. 8;
FIG. 9B is a diagram illustrating an external compensation configuration of an organic light emitting display device according to another embodiment of the present invention together with an equivalent circuit for one pixel, with respect to the implementing method of FIG. 8;
FIG. 10 is a diagram illustrating an external compensation configuration according to the implementing method of FIG. 8 together with a plurality of pixels;
FIG. 11 is a diagram illustrating another method of implementing an external compensation configuration included in an organic light emitting display device according to embodiments of the present invention;
FIG. 12A is a diagram illustrating still another method of implementing an external compensation configuration included in an organic light emitting display device according to one embodiment of the present invention;
FIG. 12B is a diagram illustrating yet another method of implementing an external compensation configuration included in an organic light emitting display device according to another embodiment of the present invention;
FIGS. 13A and 13B are diagrams illustrating configurations for data drivers included in an organic light emitting display device according to embodiments of the present invention;
FIG. 14 is a diagram illustrating a configuration of a gate driver included in an organic light emitting display device according to embodiments of the present invention; and
FIGS. 15A and 15B are diagrams comparatively illustrating numerical apertures of a display panel according to one embodiment of the present invention in which a shared node of first transistors of respective pixels is integrally configured with a reference voltage line, and a display device in which a first transistor of each pixel is configured in each pixel.

### DETAILED DESCRIPTION OF THE EXEMPLARY EMBODIMENTS

Hereinafter, some of the embodiments of the present invention will be described in detail with reference to exemplary drawings. In the following description, the same elements will be designated by the same reference numerals although they are shown in different drawings. Further, in the following description of the present invention, a detailed description of known functions and configurations incorporated herein will be omitted when it may make the subject matter of the present invention rather unclear.

In addition, terms, such as first, second, A, B, (a), (b) or the like may be used herein when describing components of the present invention. Each of these terminologies is not used to define an essence, order or sequence of a corresponding component but used merely to distinguish the corresponding component from other component(s). In the case that it is described that a certain structural element "is connected to", "is coupled to", or "is in contact with" another structural element, it should be interpreted that another structural element may "be connected to", "be coupled to", or "be in contact with" the structural elements as well as that the certain structural element is directly connected to or is in direct contact with another structural element.

**FIG. 1** is a diagram illustrating a configuration of an entire system for an organic light emitting display device 10 according to embodiments of the present invention.

Referring to FIG. 1, according to one embodiment of the present invention, an organic light emitting display device 10 includes: a display panel 11 including a plurality of data lines DL positioned in one direction, a plurality of gate lines GL positioned in another direction intersecting with the plurality of data lines, a plurality of pixels P disposed in intersection regions, respectively; a data driver 12 configured to supply a data voltage through the data lines; a gate driver 13 configured to supply a scan signal through the gate lines; and a timing controller 14 configured to control driving timing of the data driver 12 and the gate driver 13, for example.

Referring to FIG. 1, in the display panel 11, a plurality of data lines DL(1) to DL(4N) are positioned in one direction, and a plurality of gate lines GL(1) to GL(M) are positioned in another direction intersecting with the data lines DL(1) to DL(4N). Here, for the convenience of description, it is assumed that the number of data lines positioned in the display panel 11 is 4N and the number of gate lines is M. Here, N and M are natural numbers of 1 or more. In addition, "n" used for identifying respective data lines in the whole of 4N data lines is a natural number which is 1 or more and 1/4 or less of the number of data lines (1≤n≤(4N/4).

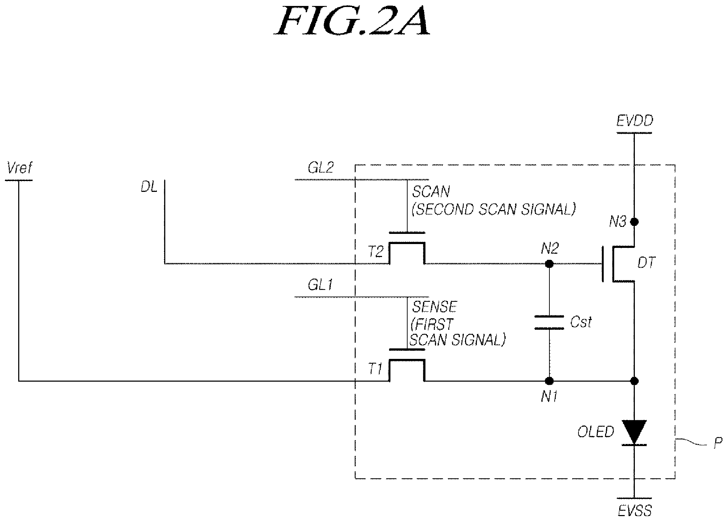

In the display panel 11, pixels P are defined in the regions, where 4N data lines DL(1) to DL(4N) and M gate lines GL(1) to GL(M) intersect with each other. A pixel structure of each pixel P will be described in more detail with reference to **FIG. 2A**.

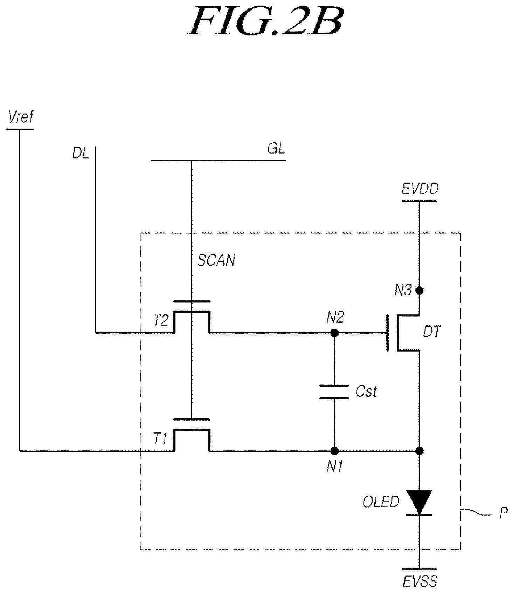

FIG. 2A is an equivalent circuit diagram for one pixel within a display panel 11 of an organic light emitting display device 10 according to one embodiment of the present invention. **FIG. 2B** is an equivalent circuit diagram for one pixel within a display panel of an organic light emitting display device according to another embodiment of the present invention.

Referring to FIG. 2A, according to one embodiment of the present invention, one pixel P within a display panel 11 of the organic light emitting display device 10 has a 3T1C structure bascially including three transistors DT, T1, and T2 and one capacitor Cst.

That is, each pixel P includes, for example, an organic light emitting diode OLED, a driving transistor DT configured to drive the organic light emitting diode OLED, a first transistor T1 controlled by a first scan signal supplied from a first gate line GL1 and connected between a reference voltage line RVL and a first node N1 of the driving transistor DT, a second transistor T2 controlled by a second scan signal supplied from a second gate line GL2 and connected between the data line DL and a second node N2 of the driving transistor DT, and a storage capacitor Cst connected between the first node N1 and the second node N2 of the driving transistor DT.

As described above, each pixel P receives two scan signals (first scan signal and second scan signal) through two gate lines (first gate line and second gate line). Hereinafter, the first scan signal may also be referred to as a "sense signal SENSE", and the second scan signal may also be referred to as a "scan signal SCAN".

Since two scan signals SCAN and SENSE are supplied to each pixel P, the basic pixel structure of one embodiment of the present invention is referred to as a "2-scan structure".

The driving transistor DT in each pixel P is a transistor, to which a driving voltage EVDD supplied from the driving voltage line DVL is applied, and which is controlled by the voltage (data voltage) of the gate node (N2) applied through the second transistor T2 so as to drive the organic light emitting diode OLED.

The driving transistor DT includes a first node N1, a second node N2, and a third node N3, in which the first node N1 is connected with the first transistor T1, the second node N2 is connected with the second transistor T2, and the third node N3 is supplied with the driving voltage EVDD.

Here, as an example, the first node N1 of the driving transistor DT may be a source node (also referred to as a "source electrode"), the second node N2 may be a gate node (also referred to as a "gate electrode"), and the third node N3 may be a drain node (also referred to as a "drain electrode"). Depending on a method of implementing a circuit, the first node, the second node, and the third node of the driving transistor DT may be changed.

In addition, the first transistor T1 is controlled by the first scan signal SENSE supplied from the first gate line GL1, and is connected between the reference voltage line(RVL) that supplies the reference voltage Vref and the first node N1 of the driving transistor DT. The first transistor T1 is also referred to as a "sensor transistor" or "sense transistor".

In addition, the second transistor T2 is controlled by the second scan signal SCAN commonly supplied from the second gate line GL2 and is connected between the corresponding data line DL and the second node N2 of the driving transistor DT. The second transistor T2 is also referred to as a "switching transistor".

In addition, the storage capacitor Cst is connected between the first node N1 and the second node N2 of the driving transistor DT to maintain the data voltage for one frame.

Meanwhile, according to one embodiment of the present invention, the pixel structure of the organic light emitting display device 10 also includes a "signal line connection structure" connected with various signal lines, such as a data line DL to supply a data voltage to each pixel P, a first gate line GL1 to supply a first scan signal SENSE to each pixel P, a second gate line GL2 to supply a second scan signal SCAN to each pixel P, a driving voltage line DVL to supply a driving voltage EVDD to each pixel, and a reference voltage line RVL to supply a reference voltage Vref to each pixel, in addition to the "basic pixel structure (3T1C-based 2-scan structure)".

Here, various signal lines further include, for example, the reference voltage line RVL to supply the reference voltage Vref to each pixel, and the driving voltage line DVL to supply the driving voltage EVDD to each pixel, in addition to the data line to supply the data voltage to each pixel, the first gate line to supply the first scan signal to each pixel, and the second gate line to supply the second scan signal to each pixel.

It has been described that the pixel structure of the organic light emitting display device 10 according to one embodiment of the present invention illustrated in FIG. 2A is a 3T1C-based 2-scan structure including the first gate line GL1 to supply the first scan signal SENSE and the second gate line GL2 to supply the second scan signal SCAN. Without being limited thereto, however, the pixel structure of the organic electroluminescent display device 10 may be a 3T1C-based 1-scan structure including one gate line GL to commonly supply the first scan signal SENSE and the second scan signal SCAN as illustrated in FIG. 2B. The above-mentioned reference voltage lines RVL and driving voltage lines DVL are positioned to be parallel with the data lines DL, and each of the number of reference voltage lines RVL and the number of driving voltage lines DVL may be equal to the number of data lines or smaller than the number of data lines.

When the number of reference voltage lines and the number of driving voltage lines are equal to the number of data lines, each pixel may not only be connected with one data line DL and one gate line GL, but also be directly connected with one driving voltage line DVL and one reference voltage line RVL.

In this case, all the signal line connection structures of respective pixels are equal to each other. That is, a basic unit of the signal line connection structure becomes one pixel so that there may be regularity of signal line connection structures per every one pixel (one pixel column).

When the number of reference voltage lines and the number of driving voltage lines are less than the number of data lines, some pixels may be directly connected with the driving voltage lines DVL and the reference voltage lines RVL, while other pixels may be connected with the driving voltage lines DVL and the reference voltage lines RVL, respectively, through a connection pattern CP without being directly connected with the driving voltage lines DVL and the reference voltage lines RVL.

In this case, all the signal line connection structures of respective pixels may not be equal to each other. However, even if not all of the connection structures of respective pixels to the signal lines are equal to each other, the connection structures of pixels to signal lines may be equal per every few pixels. That is, the unit of signal line connection structures may be some pixels rather than one pixel P, and the regularity of signal line connection structures may repeatedly appear per every few pixels (few pixel columns).

For example, the signal line connection structures may be equally repeated per every four pixels (P1, P2, P3, and P4). That is, the regularity of signal line connection structures may repeatedly appear per every four pixels (four pixel columns), in which case, the basic unit of the signal line connection structures may be four pixels (four pixel columns).

When the basic unit of signal line connection structures is four pixels (four pixel columns), the number of reference voltage lines is 1/4 of the number of data lines. That is, when the number of data lines is 4N, the number of reference voltage lines is N.

In addition, in the specification and drawings, 4 pixels P1, P2, P3, and P4 may be, for example, an R (Red) pixel, a G (Green) pixel, a B (Blue) pixel, and a W (White) pixel.

In the specification and drawings, the transistors DT, T1, and T2 are illustrated and described as an N-type merely for the convenience of description. However, according to a design change of a circuit, all the transistors DT, T1, and T2 may be changed to a P-type, or some of the transistors DT, T1, and T2 may be implemented as the N-type and the others may be implemented as the P-type. In addition, the organic light emitting diodes OLED may be changed into an inverted type.

In addition, the transistors DT, T1, and T2 described herein are also referred to as Thin Film Transistors (TFTs).

Hereinafter, the pixel structures including a basic pixel structure (3T1C-based 2-scan structure) and a signal line connection structure as briefly described above will be described in more detail with reference to **FIGs. 3A** **and** **4A**. However, FIGs. 3A and 4A illustrate a case where the basic unit of signal line connection structures is four pixels.

As described above, when the basic unit of signal line connection structures is four pixels P1 to P4 connected to the data lines DL(4n-3), DL(4n-2), DL(4n-1), and DL(4n), one reference voltage line RVL to supply the reference voltage Vref and two driving voltage lines DVL to supply the driving voltage EVDD may exist with respect to the four pixels P1 to P4.

FIG. 3A is a plan view briefly illustrating a part of a display panel 11 of an organic light emitting display device 10 according to one embodiment of the present invention, and FIG. 4A is an equivalent circuit diagram, in which the equivalent circuit diagram for one pixel illustrated in FIG. 3A is applied to four pixels.

Referring to FIGS. 3A and 4A, a signal connection structure and a basic pixel structure (3T1C-based 2-scan structure) may be confirmed with respect to a case where the basic unit of signal line connection structures is four pixels P1 to P4 that require four data lines data line DL(4n-3), DL(4n-2), DL(4n-1), and DL(4n).

Referring to FIGS. 3A and 4A, the four data lines DL(4n-3), DL(4n-2), DL(4n-1), and DL(4n) are connected to four pixels P1, P2, P3, and P4, respectively. Each of a first gate line GL1 (m) (1≤m≤M) and a second gate line GL2(m) (1≤m≤M) is connected with the four pixels P1, P2, P3, and P4.

In addition, as illustrated in FIG. 3A, each of the four pixels P1 to P4, which are respectively connected with the four data lines DL(4n-3), DL(4n-2), DL(4n-1), and DL(4n) equally includes a driving transistor DT, which receives a driving voltage EVDD to control an organic light emitting diode, a first transistor T1 (e.g., pixel P1 includes first transistor T11, pixel P2 includes first transistor T12, pixel P3 includes first transistor T13, and pixel P4 includes first transistor T14), which is controlled by a first scan signal SENSE and receives a reference voltage Vref and transmits the reference voltage Vref to a first node N1 of the driving transistor DT, a second transistor T2 which is controlled by a second scan signal SCAN and receives a data voltage Vdata and transmits the data voltage Vdata to a second node N2 of the driving transistor DT, and a capacitor Cst connected between the first node N1 and the second node N2 of the driving transistor DT.

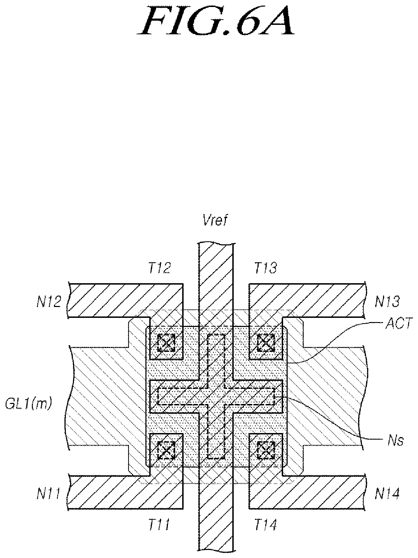

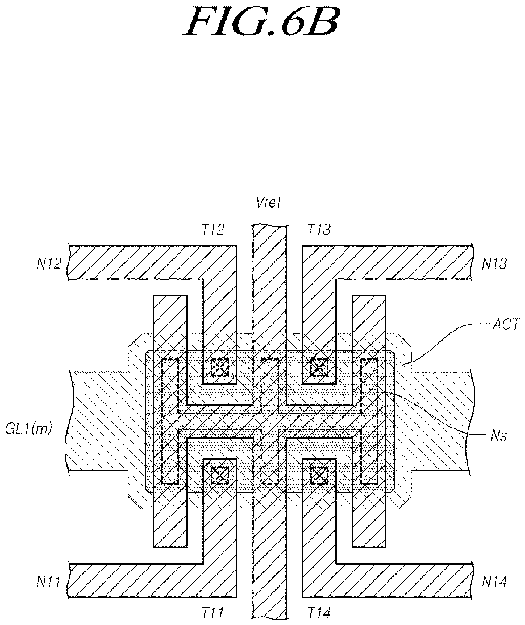

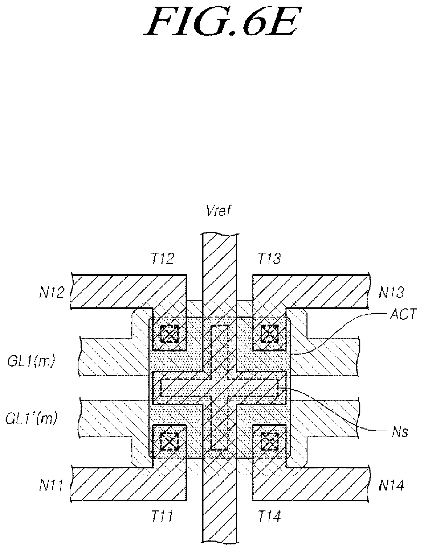

Four (first) transistors T11, T12, T13, and T14 of the pixel P1 connected with the (4n-3)^{th} data line DL(4n-3), the pixel P2 connected with the (4n-2)^{th} data line DL(4n-2), the pixel P3 connected with the (4n-1)^{th} data line DL(4n-1), and the pixel P4 connected with the (4n)^{th} data line DL(4n) share a node Ns of one of drains and sources configured integrally with the reference voltage line, nodes N11, N12, N13, and N14 of the other of respective drains or sources are individually configured, and each of the nodes N11, N12, N13, and N14 is connected with a first node N1 of the driving transistor DT of the respective pixel directly or through a connection pattern. In other words, first source/drain nodes (e.g., source nodes or drain nodes) of the four first transistors T11, T12, T13, T14 may be configured as the shared node Ns formed integrally with the reference voltage line RVL while second source/drain nodes (e.g., drain nodes or source nodes) of the four first transistors T11, T12, T13, T14 may be configured as individual nodes N11, N12, N13, N14. See, e.g., FIGs. 6A, 6B, 6E-6G for further illustrations of individual nodes N11, N12, N13, N14 and shared node Ns.

The sources and drains of the first transistors T11, T12, T13, and T14 may be oppositely operated depending on a semiconductor type (*e.g*., P-type or N-type). In addition, the sources and drains within the first transistors T11, T12, T13, and T14 may changedly act depending on the operation. Accordingly, one node among the drains or sources configured integrally with the reference voltage line in the first transistors T11, T12, T13, and T14 is referred to as a shared node Ns, the other nodes which are indiviually configured and each connected with the first node N1 of the driving transistor DT directly or through the connection pattern are referred to as individual nodes N11, N12, N13, and N14.

A semiconductor layer or an active layer ACT is positioned between the shared node Ns and four individual nodes N11, N12, N13, and N14.

The individual nodes N12 and N13 of the first transistors T12 and T13, which are respectively included in the pixel P2 connected with the (4n-2)^{th} data line DL(4n-2) and the pixel P3 connected with the (4n-1)^{th} data line DL(4n-1), are directly connected with the first node N1 of the driving transistor DT. In addition, the individual nodes N11 and N14 of the first transistors T11 and T14 which are respectively included in the pixel P1 connected with the (4n-3)^{th} data line DL(4n-3) and the pixel P4 connected with the (4n)^{th} data line DL(4n) are connected with the first node N1 of the driving transistor through the connection pattern CP.

In this manner, each of the four pixels P1 to P4 connected with four data lines DL(4n-3), DL(4n-2), DL(4n-1), and DL(4n) has a configuration in which each of the first transistor T1 and the second transistor T2 is supplied with the first scan signal and the second scan signal. As described above, the pixel structure of each pixel described above is referred to as a "3T1C-based 2-scan structure".

Meanwhile, even if the four pixels P1 to P4 connected with the four data lines DL(4n-3), DL(4n-2), DL(4n-1), and DL(4n) are equal to each other in terms of, for example, the number of transistors, the number of capacitors, and the number of scan signals, they may be different from each other in terms of the signal line connection structure (signal application method) to receive, for example, the data voltage, the driving voltage, and the reference voltage. However, the signal line connection structures among the four pixels P1 to P4 connected with the four data lines DL(4n-3), DL(4n-2), DL(4n-1), and DL(4n) have certain regularity and symmetry.

As described above, when the basic unit of signal line connection structures is four pixels P1 to P4 that require four data lines DL(4n-3), DL(4n-2), DL(4n-1), and DL(4n), one reference voltage line RVL for supplying a reference voltage Vref may exist and two driving voltage lines DVL for supplying a driving voltage EVDD may exist with respect to four pixels P1 to P4.

Since two gate lines GL1(m) and GL2(m) exist with respect to one pixel row as described above, it is possible to differently control the first transistor T1 and the second transistor T2 included in each of the pixels existing in one pixel row. This is due to the fact that the basic pixel structure of one embodiment of the present invention has the 3T1C-based 2-scan structure.

**FIG. 3B** is a plan view briefly illustrating a part of a display panel of an organic light emitting display device according to another embodiment of the present invention. **FIG. 4B** is an equivalent circuit diagram, in which the equivalent circuit diagram for one pixel illustrated in FIG. 3B is applied to four pixels.

It has been described that the pixel structure of the organic light emitting display device 10 according to one embodiment of the present invention illustrated in FIGS. 3A and 4A is the 3T1C-based 2-scan structure including the first gate line GL1(m) to supply the first scan signal SENSE and the second gate line GL2(m) to supply the second scan signal SCAN. Without being limited thereto, however, the pixel structure may be a 3T1C-based 1-scan structure including one gate line GL(m) to commonly supply the first scan signal SENSE and the second scan signal SCAN as illustrated in FIGS. 3B and 4B. Herein, supplying the first scan signal and the second scan signal through two different gate lines GL1(m) and GL2(m) like the 3T1C-based 2-scan structure or through one common gate line GL(m) like the 3T1C-based 1-scan structure means that the first scan signal and the second scan signal are supplied through a gate line.

As described above, since the display panel 11 has a symmetric structure in the four pixel column P1 to P4 unit (a single symmetric structure), there are advantages in that the panel structure may be made to be simple and compact even with the 3T1C pixel structure that necessarily requires two scan signals SENSE and SCAN, the incidence probability of defects may be reduced accordingly, and the numerical aperture may also be increased. Due to this, it is possible to manufacture a good quality panel with high yield. In particular, it is possible to manufacture a high resolution and large area panel with higher quality and high yield.

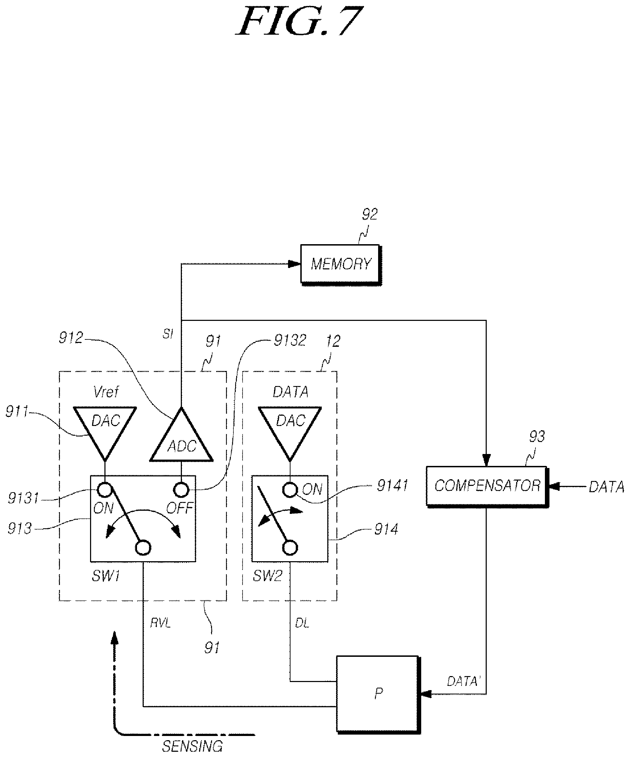

Meanwhile, descriptions will be made, with reference to FIG. 7, on an efficient sensing function that enables characteristic information of driving transistors DT included in respective pixels to be determined, a compensation function that determines the characteristic information of the driving transistors DT included in the respective pixels based on the sensed information and compensates for the characteristic information of the driving transistor DT so as to reduce a characteristic deviation among the driving transistors DT in the respective pixels, and a structure that allows the sensing function and the compensation function to be efficiently executed, in the organic light emitting display device 10 according to one embodiment of the present invention.

**FIG. 5** illustrates various examples that constitute the shapes of the shared nodes of the first transistors.

Referring to FIG. 5, the shared node Ns may have, for example, a "l" shape, a "-" shape, a "¬" shape, a "L" shape, a "⊏" shape, or a shape obtained by combining two or more of partially rounded forms of the shapes.

As in FIG. 5(A), the shared node Ns may have a shape obtained by combining two of partially rounded forms of the "l" shape, the "-" shape, the "¬" shape, the "L" shape, and the "⊏" shape. For example, the shared node Ns may have a "⊥" shape obtained by combining two "L" shapes or a "T" shape obtained by combining two "¬" shapes. In addition, the shared node Ns may have a "⊥" shape obtained by combining two "L" shapes, in each of which the bent portion is rounded, and a "T" shape obtained by combining two "¬" shapes, in each of which the bent portion is rounded.

In addition, as in FIG. 5(B), the shared node Ns may have a shape obtained by combining four of the "l" shape, the "-" shape, the "¬" shape, the "L" shape, the "⊏" shape, and the partially rounded shapes thereof. For example, the shared node Ns may have a "+" shape obtained by combining two "¬" shapes and two "L" shapes, or a " 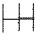 " shape obtained by four "⊏" shapes.

In addition, as in FIG. 5(c), the shared node Ns may have a shape obtained by combining three of the "l" shape, the "-" shape, the "¬" shape, the "L" shape, the "⊏" shape, and the partially rounded shapes thereof. For example, the shared node Ns may have a " 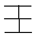 " shape obtained by combining two "⊏" shapes and one "l" shape.

It has been described with reference to FIG. 5 that the shared node Ns may have a shape obtained by combining two to four of the "l" shape, the "-" shape, the "¬" shape, the "L" shape, the "⊏" shape, and the partially rounded shapes thereof, by way of an example. Without being limited thereto, however, the shared node Ns may have any shape obtained by combining two or more shapes.

Hereinafter, the first transistors T11, T12, T13, T14 of the first to fourth pixels P1 to P4 in the cases where the shared node Ns has a "+" shape, a shared node of a " 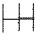 " shape, a "⊥" shape, and a " 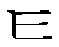 " shape will be described in detail with reference to FIGS. 6A to 6G, by way of examples.

Referring to FIGS. 4A and 6A, the four first transistors T11, T12, T13, and T14 of the pixel P1 connected with the (4n-3)^{th} data line DL(4n-3), the pixel P2 connected with the (4n-2)^{th} data line DL(4n-2), the pixel P3 connected with the (4n-1)^{th} data line DL(4n-1), and the pixel P4 connected with the (4n)^{th} data line DL(4n) share the shared node Ns which has the "+" shape and is formed integrally with the reference voltage line, and each of the individual nodes N11, N12, N13, and N14 is individually formed.

At this time, the individual nodes N12 and N13 of the first transistors T12 and T13 included in each of the pixel P2 connected with the (4n-2)^{th} data line DL(4n-2) and the pixel P3 connected with the (4n-1)^{th} data line DL(4n-1) are directly connected with the first node N1 of the driving transistor DT. In addition, the individual nodes N11 and N14 of the first transistors T11 and T14 included in each of the pixel P1 connected with the (4n-3)^{th} data line DL(4n-3) and the pixel P4 connected with the (4n)^{th} data line DL(4n) are connected with the first node N1 of the driving transistor DT through the connection pattern CP.

A (e.g., one) semiconductor layer or active layer ACT is positioned between the shared node Ns and four individual nodes N11, N12, N13, and N14. Four first transistors T11, T12, T13, and T14 are controlled by the first scan signal supplied to a gate node which is integral with the first gate line GL1(m) positioned below the semiconductor layer or active layer ACT or is connected with the first gate line GL1(m).

The semiconductor layer or active layer ACT exists as one common layer between the shared node Ns and four individual nodes N11, N12, N13, and N14 as illustrated in **FIG. 6A****.** In addition, although it has been described by way of an example that four first transistors T11, T12, T13, and T14 are bottom gate structures in which the gate node is positioned below the source/drain node, the first transistors T11, T12, T13, and T14 may be top gate structures in which the gate node is positioned above the source/drain node.

Referring to **FIG. 6B**, four first transistors T11, T12, T13, and T14 of four pixels P1 to P4 share a shared node Ns of a " 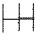 " shape which is formed integrally with the reference voltage line and individual nodes N11, N12, N13, and N14 are individually formed.

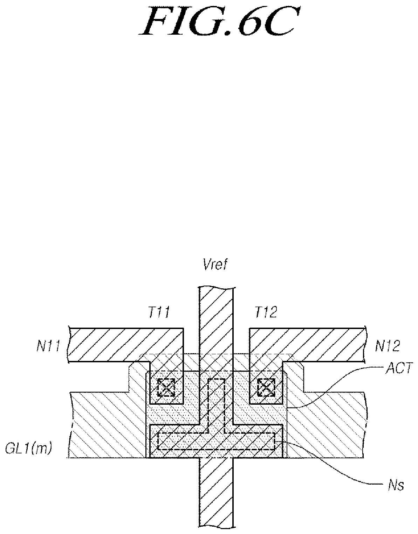

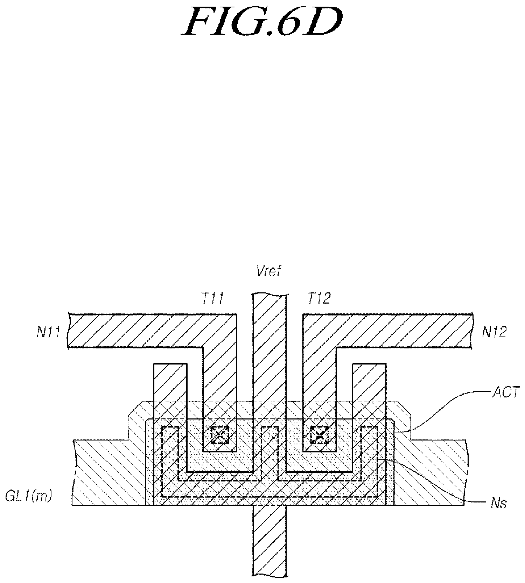

It has been described in the above-described embodiment that four pixels P1 to P4 are symmetric with reference to the reference voltage line, the four first transistors T11, T12, T13, and T14 of the four pixels P1 to P4 share the shared node Ns formed integrally with the reference voltage line, and each of individual nodes N11, N12, N13, N14 is individually formed. In a comparative example, two pixels may be positioned at opposite sides with reference to the reference voltage line (symmetrically or asymmetrically), two first transistors T11 and T12 of two pixels P1 and P2 may share a shared node Ns having a "⊥" shape (illustrated in FIG. 6C) or a " 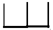 " shape (illustrated in FIG. 6D, another comparative example) which is integrally formed with the reference voltage line, and each of the individual node N11 and N12 may be individually formed.

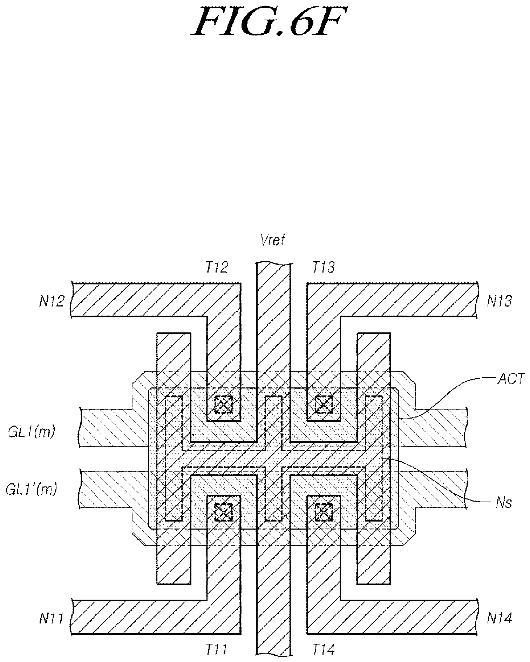

In the above-described embodiment, four first transistors T11, T12, T13, and T14 of four pixels P1 to P4 are controlled by a first scan signal supplied through one first gate line GL1(m) that supplies a first scan signal in a 3T1C-based 2-scan structure, or through one common first gate line GL(m) that supplies a first scan signal and a second scan signal in a 3T1C-based 1-scan structure. As comparative examples useful for understanding the invention, four first transistors T11, T12, T13, and T14 may be controlled by two first scan signals supplied through two first gate lines GL1(m) and GL1'(m), as illustrated in FIGS. 6E and 6F, or four first transistors T11, T12, T13, and T14 may be controlled by four first scan signals supplied through four first gate lines, respectively (not shown). For example, first transistors T11 and T14 may be controlled by a first first scan signal supplied through a first first gate line GL1(m), while first transistors T12 and T13 may be controlled by a second first scan signal supplied through a second first gate line GL1'(m), as shown in Figs. 6E and 6F.

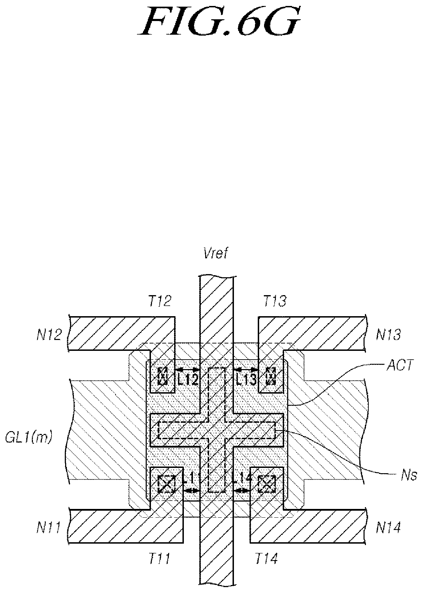

In addition, it has been described in the above-described embodiments that the distance (e.g. widths/lengths) between the shared node of four first transistors T11, T12, T13, and T14 of four pixels P1 to P4 and four individual nodes are all equal to each other, the distance (e.g. width/length) between the shared node and individual node of at least one of four first transistors T11, T12, T13, and T14 may be different from that of another first transistor. For example, as illustrated in FIG. 6G, among four first transistors T11, T12, T13, and T14, the distances (widths/lengths) L12 and L13 between the shared node Ns and two individual nodes N12 and N13 may be different from the distances (widths/lengths) L11 and L14 between the shared node and the other two individual nodes N11 and N14. In other words, the distances L11 and L14 between the shared node Ns and the other two individual nodes N11 and N14 may be longer than the distances (widths/lengths) L12 and L13 between the shared node Ns and two individual nodes N12 and N13. Therefore current gains of two transistors T11 and T14 may be larger than those of two transistor T12 and T13.

The four first transistors T11, T12, T13, and T14 described above with reference to FIGS. 5 and 6 are associated with the four pixels P1 to P4 of the display panel 11 of the display device 10 described with reference to FIG. 1. In comparative examples useful for understanding the invention, the transistor structure described with reference to FIGS. 5 and 6 may be included in any type of display device. At this time, the transistor structure for a display device includes two or more transistors which share a voltage line of one direction that supplies a voltage to pixels and one of drains and sources integrally formed with the voltage line, and respectively include the other of the drains and sources which are formed separately and connected to different nodes directly or through a connection pattern. This transistor structure is referred to as a rotary transistor.

**FIG. 7** is a diagram briefly illustrating an external compensation configuration included in an organic light emitting display device 10 according to embodiments of the present invention.

Referring to FIG. 7, in order to compensate for characteristic (*e.g*., threshold voltage and/or mobility) deviations of the driving transistor DT (in other words, deviations in characteristics of the driving transistor DT) in each pixel P which may cause unbalanced luminance among pixels, the organic light emitting display device 10 according to embodiments of the present invention may include, as a compensation configuration, a sensor 91 configured to sense a voltage for determining characteristic information (in other words, information representing characteristics) of a driving transistor DT (*e.g*., threshold voltage and/or mobility), a memory 92 configured to store the sensed voltage, a compensator 93 configured to determine the characteristic information of the driving transistor DT based on the sensed voltage and compensate for the characteristic information.

The sensor 91 may sense a voltage for determining characteristic information of the driving transistor DT in each pixel P, in particular the voltage of the first node N1 of the driving transistor DT of each pixel P.

As illustrated in FIG. 7, the sensor 91 may include, for example, a Digital Analog Converter (DAC) 911 configured to convert the reference voltage Vref supplied from a reference voltage source into an analog value, an Analog Digital Converter (ADC) 912 configured to convert the voltage sensed at the first node N1 of the driving transistor DT of each pixel connectable with the sensor 91 to a digital value, and a first switch 913 configured to perform switching so as to cause one of reference voltage supply node 9131 which is supplied with the reference voltage Vref which is converted into an analog value by the digital analog converter 911 and a sensing node 9132 connected to the analog digital converter 912 to be connected with a reference voltage line RVL.

In order to sense the voltage for determining the characteristic information of the driving transistor DT, it is necessary to apply a predetermined voltage to each of the first node N1 and the second node N2 of the driving transistor DT, to cause the voltage at the first node N1 of the driving transistor DT to be varied, and to measure the varied voltage as a sensing voltage.

In connection with this, when the reference voltage supply node 9131 and the reference voltage line RVL are connected with each other by the switch 913, the reference voltage Vref, which is converted into an analog value by the digital analog converter 911, is applied to the first node N1 of the driving transistor DT. Then, a predetermined voltage should also be applied to the second node N2 of the driving transistor DT. One embodiment of the present invention applies a data voltage Vdata to the second node N2 of the driving transistor DT from the data line DL connected with the corresponding pixel. Thereafter, in order to sense the varied voltage at the first node N1 of the driving transistor DT, one embodiment of the present invention may include a (e.g., one) second switch 914 in each data line, in which the second switch 914 performs switching such that a data voltage output point 9141 of the data driver 12 is turned ON to be connected with the corresponding data line DL or the data voltage output point 9141 of the data driver 12 is turned OFF to be floated with the corresponding data line DL, as illustrated in FIG, 7. The second switch 914 may be considered as a component which is functionally included in the sensor 91 corresponding to the corresponding pixel P.

The sensor 91 described above may be included in the inside or outside of the data driver 12.

A plurality of sensors 91 may be provided, in which case, each sensor 91 may be provided per one data line, or per some data lines. In addition, each sensor 91 may be provided per one reference voltage line RVL.

The sensor 91 stores the sensed voltage in the memory 92 in digital form or transmits the sensed voltage to the compensator 93 so that the characteristic information of the driving transistor DT can be compensated for.

After receiving the sensed voltage from the sensor 91, the compensator 93 is capable of performing data conversion processing based on the voltage transmitted from the sensor 91 in digital form so as to compensate for the characteristic information of the driving transistor DT including one or both of a threshold voltage and mobility.

The above-mentiond compensator 93 may be located at any position within the organic light emitting display device 10 as long as it can receive the sensed voltage in digital form from the sensor 91.

For example, the compensator 93 may be implemented to be included within the timing controller 14, within the data driver 12, or outside of the timing controller 14 and data driver 12.

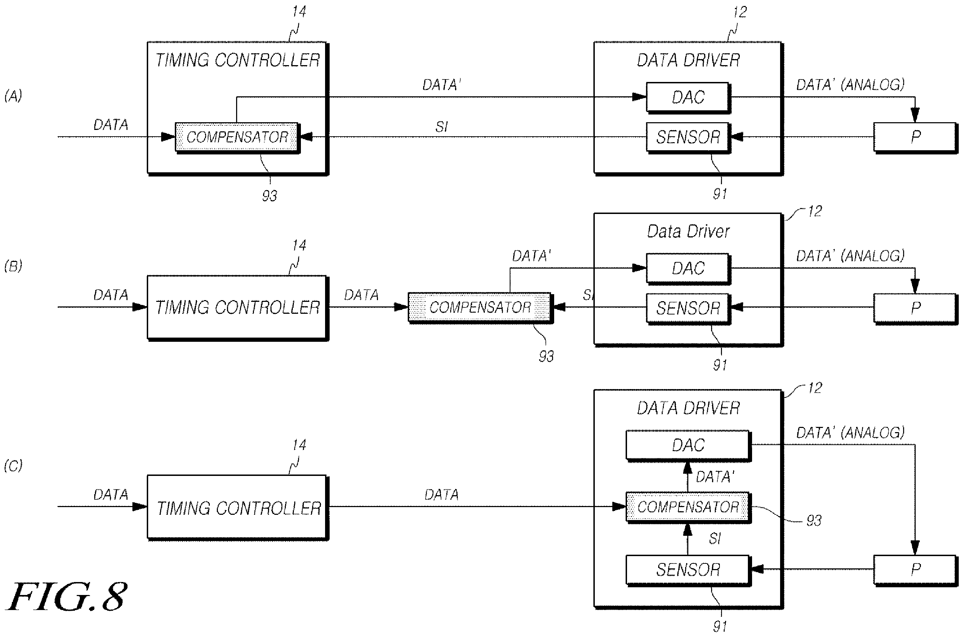

**FIG. 8** is a diagram conceptually exemplifying methods of implementing external compensation configurations included in an organic light emitting display device 10 according to embodiments of the present invention, in particular (A) a case, in which the compensator 93 is implemented to be included within the timing controller 14, (B) a case, in which the compensator 93 is implemented to be included outside of the timing controller 14 and the data driver 12, and (C) a case, in which the compensator 93 is implemented to be included in the data driver 12.

In FIG. 8, it is assumed that the sensor 91 is implemented to be included in the data driver 12.

Referring to **FIG. 8(A)**, in the case where the compensator 93 is implemented to be included within the timing controller 14, the voltage SI sensed in the corresponding pixel P by the sensor 91 is transmitted to the compensator 93 within the timing controller 14, and the compensator 93 included within the timing controller 14 may determine the characteristic information of the driving transistor DT based on the voltage SI transmitted from the sensor 91, convert, based on this, the data supplied from the outside (Data) into transmitted compensation data (Data') and supply the compensation data (Data') to the Digital Analog Converter (DAC) within the data driver 12. As a result, the DAC within the data driver 12 converts the compensation data in digital form (Data') supplied from the compensator 93 into analog data and supplies the converted compensation data to the corresponding pixel P.

Referring to **FIG. 8(B)**, in the case where the compensator 93 is implemented to be included outside of the timing controller 14 and the data driver 12, the voltage SI sensed by the sensor 91 from the corresponding pixel P is transmitted to the compensator 93 located outside of the data driver 12 and the timing controller 14, the compensator 93 may determine the characteristic information of the driving transistor DT based on the voltage SI transmitted from the sensor 91, convert, based on the characteristic information, data supplied from the timing controller 14 (Data) into compensation data (Data'), and supply the compensation data to the data driver 12. The data driver 12 converts the compensation data in digital form (Data') supplied from the compensator 93 into analog data through the DAC located therein, and supplies the converted compensation data to the corresponding pixel P.

Referring to **FIG. 8(C)**, in the case where the compensator 93 is implemented to be included in the data driver 12, the sensor 91 within the data driver 12 transmits the voltage SI sensed from the corresponding pixel P to the compensator 93 within the data driver 12, the compensator 93 may determine the characteristic information of the driving transistor DT based on the voltage SI transmitted from the sensor 91, convert, based on this, the data supplied from the timing controller 14 (Data) into compensation data (Data'), and supply the compensation data to the DAC. As a result, the DAC converts the compensation data in digital form (Data') supplied from the compensator 93 into an analog form, and supplies the compensation data (data voltage) converted into the analog form to the corresponding pixel P.

In FIG.8(B) and FIG. 8(C), in the method of receiving the data (Data), the compensator 93 may be supplied with the data directly from the timing controller 14. However, when the timing controller 14 stores the data in the memory, the compensator 93 may be supplied with the data in the manner of reading the data stored in the memory.

The implementing example of the compensator 93 illustrated in FIG. 8(A) to FIG. 8(C) is a digital-based compensation method (data conversion method) that performs compensation by converting the data in digital form (Data) into compensation data in digital form (Data'). In this case, the compensation data in digital form (Data') may be generated through calculation processing that adds/substracts a digital value of the characteristic information of the driving transistor DT to/from the data in digital form (Data).

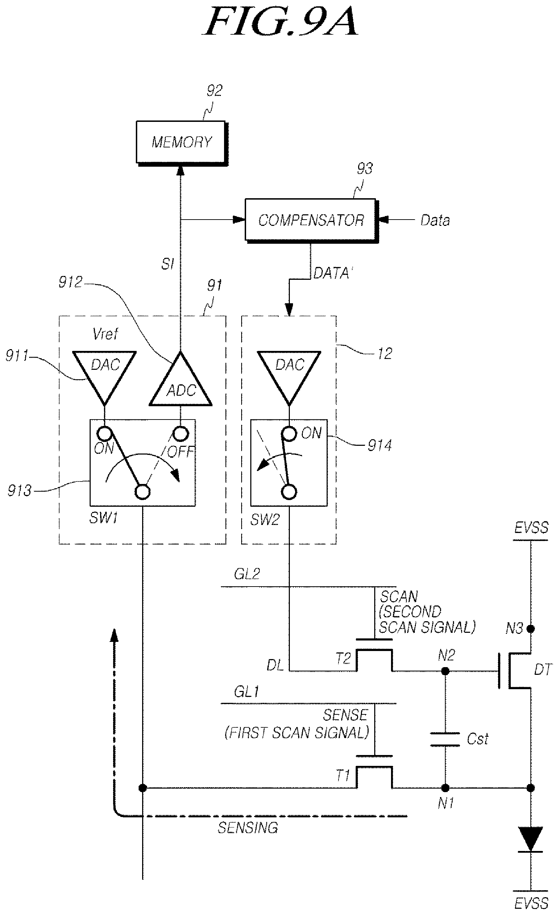

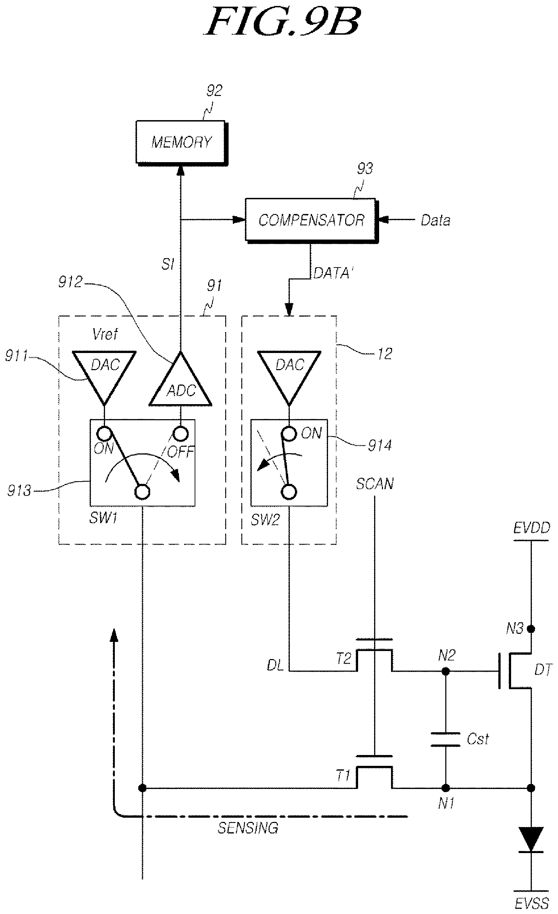

**FIG. 9A** is a diagram illustrating an external compensation configuration of an organic light emitting display device according to one embodiment of the present invention together with an equivalent circuit for one pixel, with respect to the implementing method of FIG. 8. **FIG. 9B** is a diagram illustrating an external compensation configuration of an organic light emitting display device according to another embodiment of the present invention together with an equivalent circuit for one pixel, with respect to the implementing method of FIG. 8.

Meanwhile, when the number of the reference voltage lines and the number of data lines are equal to each other, that is, when one reference voltage line exists in each pixel P arranged in the horizontal direction (the other direction), sensors 91 respectively corresponding to pixels P arranged in the horizontal direction (the other direction) may exist. Then, a sensing operation may be performed for all the pixels arranged in the horizontal direction (the other direction) simultaneously. That is, in FIG. 5, when reference voltage lines RVL exist to correspond to four pixels P1 to P4, respectively, the varied voltages at the first nodes N1 of the driving transistors DT in four respective pixels P1 to P4 may be simultaneously sensed.

However, when the number of reference voltage lines is smaller than the number of data lines, for example, when the number of reference voltage lines is 1/4 of the number of data lines, that is, one reference voltage line exists per every four pixels P arranged in the horizontal direction (the other direction), it is impossible to perform the sensing operation for all the pixels arranged in the horizontal direction (the other direction) simultaneously. The sensing operation may be performed for one pixel per every four pixels. That is, when one reference voltage line RVL exists for four pixels P1 to P4 as in FIG. 5, the varied voltages at the first nodes N1 of driving transistors DT of the four respective pixels P1 to P4 cannot be simultaneously sensed, and at a specific time point, only the varied voltage of the first node N1 of the driving transistor DT of one pixel among the four pixels P1 to P4 can be sensed.

Accordingly, at the specific time point a function may be required for selecting a pixel for sensing the varied voltage at the first node N1 of the driving transistor DT among the four pixels P1 to P4.

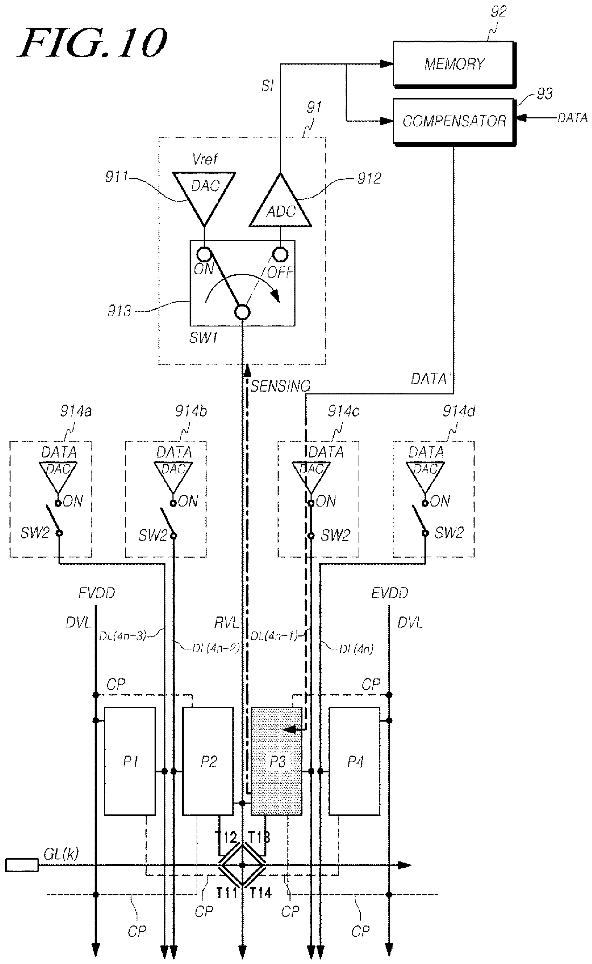

**FIG. 10** is a diagram illustrating an external compensation configuration according to the implementing method of FIG. 8 together with a plurality of pixels P1 to P4.

FIG. 10 illustrates a method in which a pixel P3 connected with a (4n-1)^{th} data line DL(4n-1) among four pixels P1 to P4 is selected, a varied voltage at the first node N1 of the driving transistor DT of the selected pixel is sensed so as to determine and compensate for characteristic information (threshold voltage and/or mobility) of the driving transistor DT of the sensed pixel.

Referring to FIG. 10, in order to select the pixel P3 connected with the (4n-1)^{th} data line DL(4n-1) among the four 4 pixels P1 to P4, a timing controller 14 may send a control sinal (second control signal) to each sensor 91 or data driver 12 that causes only a second switch 914c, which switches the connection between the pixel P3 and the (4n-1)^{th} data line DL(4n-1), to be turned ON, and causes the remaining second switches 914a, 914b, and 914d to be turned OFF, among four second switches 914a, 914b, 914c, 914d that switch the connection between the four pixels P1 to P4 and four data lines DL(4n-3), DL(4n-2), DL(4n-1) and DL(4n) capable of supplying the data voltage.

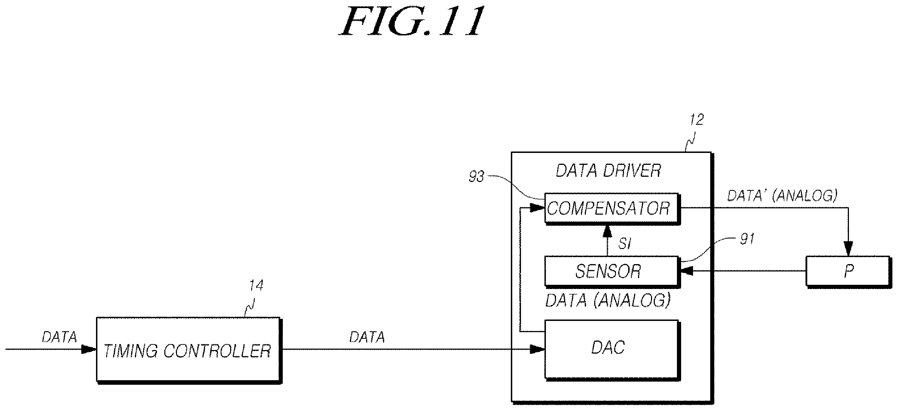

Meanwhile, besides the implementation examples of the compensator 93 illustrated in FIG. 8(A) to FIG. 8(C), that is, the digital-based compensation method (data conversion method), according to another implementation example as illustrated in **FIG. 11**, the data driver 12 receives data in digital form (Data) supplied from the timing controller 14, the DAC of the data driver 12 converts the data in digital form (Data) into an analog form using a gamma reference voltage, and the compensator 93 converts the characteristic information SI of the transistor DT transmitted from the sensor 91 into an analog value so that, based on the characteristic information converted into the analog value, the converted analog data (Analog Data) can be converted to generate a data voltage as compensation data. This method is a complete analog-based compensation method (data conversion method).

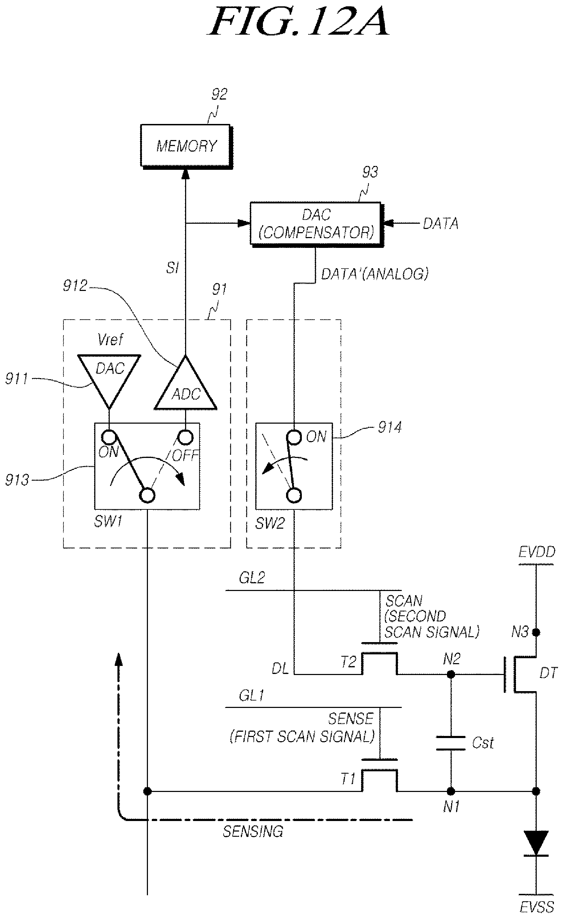

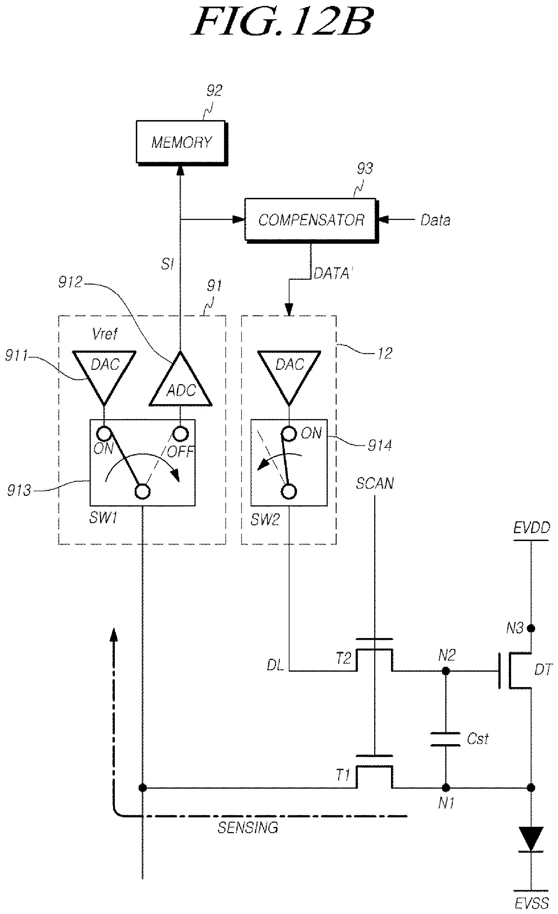

Besides the complete analog-based compensation method, according to another implementation example as illustrated in **FIGS. 12A** **and** **12B**, the data driver 12 may receive data in digital form (Data) supplied from the timing controller 14, and the DAC (including the compensator 93) of the data driver 12 may generate compensation data (Data') using the characteristic information of the transistor DT transmitted from the sensor 91 when converting the data in digital form (Data) into an analog form using a gamma reference voltage, and convert the compensation data into an analog form to generate a data voltage. Strictly speaking, this method converts data into a digital form. However, as the conversion is performed in a digital-to-analog conversion step (DAC step), this method is referred to as an analog-based compensation method (data conversion method).

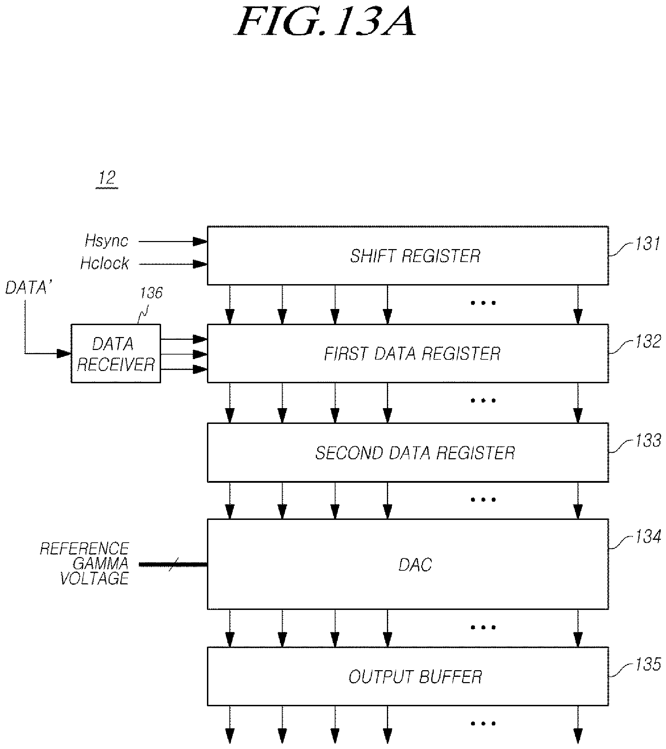

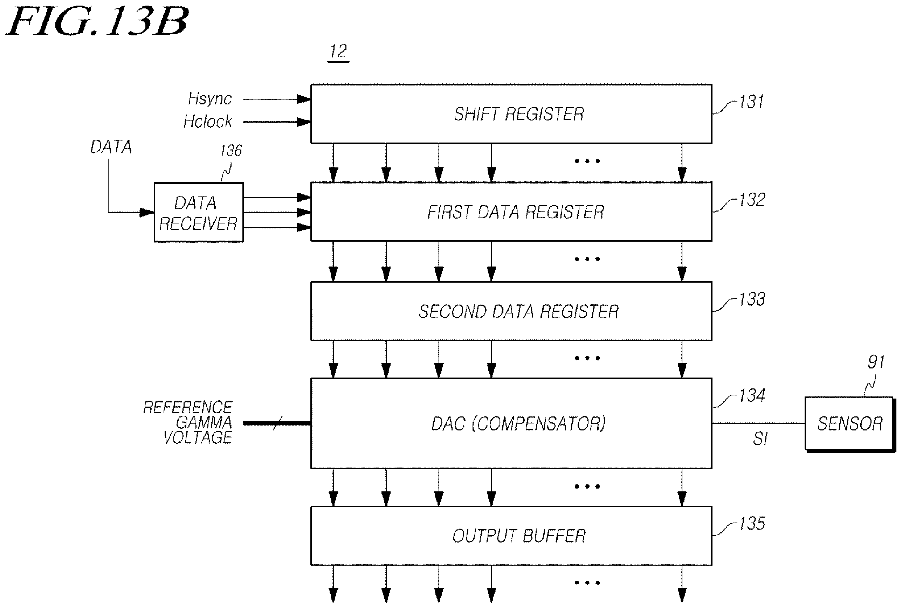

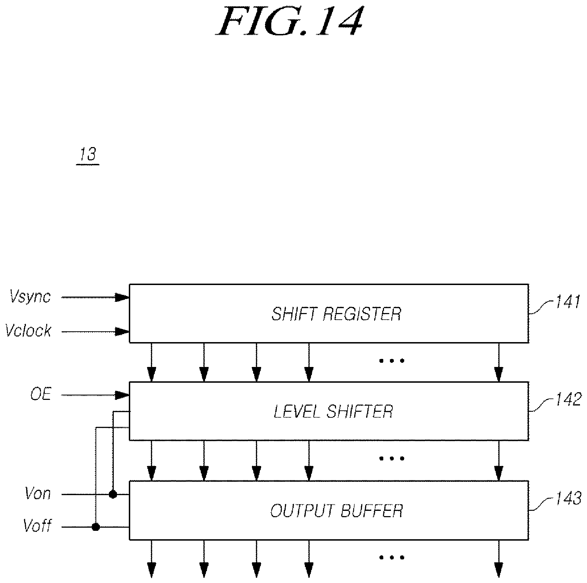

In the foregoing, among the components of the entire system of the organic light emitting display device 10 according to the embodimenets of the present invention, the display panel 11, the sensor 91, the compensator 93, etc. have been described, and hereinafter, a data driver 12, and a gate driver 13 will be briefly described with reference to FIGS. 13A, 13B, and 14.

**FIGS. 13A** **and** **13B** are diagrams illustrating configurations for data drivers 12 included in an organic light emitting display device 10 according to embodiments of the present invention.

FIG. 13A is a diagram illustrating the data driver in a case where a data driver 12 receives the compensation data to drive a data line, and FIG. 13B is a view illustrating a data driver including a compensator 93.

Referring to FIG. 13A, a data driver 12 included in the organic light emitting display device 10 according to one embodiment of the present invention includes, for example, a shift register 131, a first data register 132, a second data register 133, a digital analog converter 134, an output buffer 135, and a data receiver 136.

The data receiver 136 receives compensation data (Data') from the compensator 93 included in the inside of the timing controller 14 or the data driver 12 or the compensator 93 included in the outside of the timing controller 14 and the data driver 12, converts the compensation data into predetermined bit digital data (in other words, digital data having a predetermined number of bits) for each of RGB and output the converted data, i.e. the predetermined bit digital data.

The shift register 131 controls an operating time with a horizontal clock signal Hclock and a horizontal synchronous signal Hsync for line-by-line driving. That is, the shift register 131 receives an input of the horizontal synchronous signal Hsync and the horizontal clock signal Hclock from the timing controller 14, and causes all the data (Data') corresponding to one gate line GL, which has selected the horizontal synchronous signal Hsync as a start signal, to be synchronized to the horizontal clock signal Hclock and to be sequentially sampled and stored in the first data register 132.

The first data register 132 sequentially stores data (Data') to be implemented by the pixels of the (m-1)^{th} gate line GL(m-1).

The second data register 133 stores the data (Data') stored in the first data register 132 according to the next horizontal synchronous signal Hsync. At this time, the data (Data') to be implemented by the pixels of the m^{th} gate line GL(m) are sequentially stored in the first data registor 152.

Each of the first data register 132 and second data register 133 described above may be implemented by a latch in which an input and an output are connected with each other through two inverters, and thus, the first data register 132 and the second data registor 133 are also referred to as a first latch and a second latch, respectively.

The DAC 134 converts the data in digital form (Data') stored in the second data register 133 into an analog type data voltage with reference to a gamma reference voltage supplied from the outside.

The output buffer 135 amplifies a pixel driving force, that is, causes the data voltage to have a current driving capability sufficient for driving a data line, and supplies the data voltage through the data line.

FIG. 13B is a view illustrating a data driver 12 including the compensator 93.

Referring to FIG. 13B, the data driver 12 receives non-compensated data from the timing controller 14, and the compensator 93 included therein compensates for the data to be capable of driving the data line.

Since the data driver 12 illustrated in FIG. 13B receives non-compensated data unlike the data driver 12 illustrated in FIG. 13A, the functions of the data receiver 136 and the DAC 134 become different from each other.

Referring to FIG. 13B, the data receiver 136 receives an input of data (Data) prior to compensation from the timing controller 14, converts the data (Data) into bit digital data for each RGB/RWGB, and outputs the converted data.

The DAC 134 may convert the data in digital form (Data) stored in the second data register 133 into the analog type data voltage by further taking a sensing voltage SI further input from the sensor when it converts the data in digital form (Data) stored in the second data registor 133 into the analog type data voltage with reference to the gamma reference voltage supplied from the outside. Accordingly, the DAC 134 included in the data driver(12) of FIG. 13B includes the compensator 93 as an internal component.

**FIG. 14** is a diagram illustrating a configuration of a gate driver 13 included in an organic light emitting display device 10 according to embodiments of the present invention.

Referring to FIG. 14, a gate driver 13 included in an organic light emitting display device 10 according to one embodiment of the present invention includes, for example, a shift register 141, a level shifter 142, and an output buffer 143.

The shift register 141 starts generating scan pulses by receiving a vertical synchronous signal Vsync that notifies initiation of one frame from a timing controller 14, and causes the outputs of scan pulses to be sequentially turned ON according to a vertical clock signal Vclock. In addition, a logic arithmetic operation circuit may be included to prevent an influence of signal delay by shortening a charging time of a gate line using an output-enabled signal OE.

The level shifter 142 converts the scan pulses into a voltage that may turn ON/OFF first and second transistors T1 and T2 (included in each pixel). That is, depending on an ON voltage signal Von and an OFF voltage signal Voff, the level shifter 142 converts a low voltage into an ON voltage Von higher than a predetermined voltage required for turning ON or turning OFF the first and second transistors T1 and T2 and an OFF voltage Voff lower than the predetermined voltage.

The output buffer 143 may be configured as a circuit that outputs a scan signal by improving a current driving capability to be suitable for driving a gate line GL having an RC load.

Meanwhile, the gate driver 13 supplies the scan signal to the gate nodes of the first and second transistors T1 and T2 through one gate line GL.

In addition, the gate driver 13 may supply, according to a control signal from the timing controller 14, a scan signal which is maintained for one horizontal time HT or more at a scan signal level (second level VGH or first level VGL) which causes the first and second transistors T1 and T2 to be turned ON. Here, the one horizontal time may be a time, for which a data voltage is applied at the second level VGH. In this view point, supplying the scan signal that causes the first and second transistors T1 and T2 to be turned ON for one horizontal time or more means that the length of time in which the scan signal, which causes the first and second transistors T1 and T2 to be turned ON, is supplied may be equal to or longer than the length of time in which the data voltage is supplied at the second level VGH, that is, the scan signal, which causes the first and second transistors T1 and T2 to be turned ON, is supplied longer than the data voltage having the second level VGH.

In addition, the gate driver 13 may supply, according to a control signal of the timing controller 14, a scan signal, in which a time point where the scan signal is changed to the scan signal level (second level VGH or first level VGL), which causes the first and second transistors T1 and T2 to be turned ON is faster than a time point where the data voltage is applied.

As described above, the reason for supplying the scan signal, which is maintained for one horizontal time HT or more at a scan signal level (second level VGH or first level VGL) which causes the first and second transistors T1 and T2 to be turned ON, or supplying the scan signal, in which a time point where the scan signal is changed to the scan signal level (second level VGH or first level VGL), which causes the first and second transistors T1 and T2 to be turned ON is faster than a time point where the data voltage is applied, is for data charging.

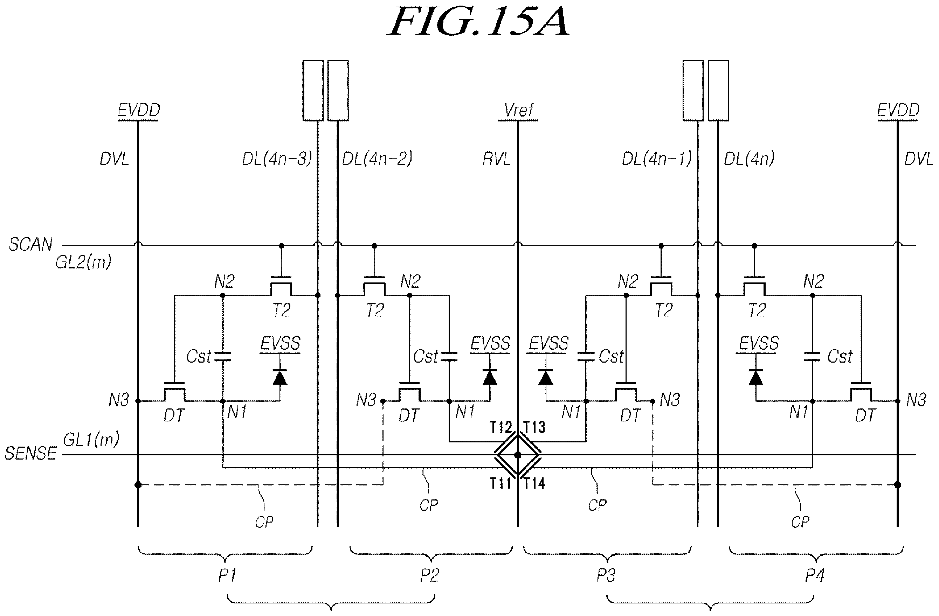

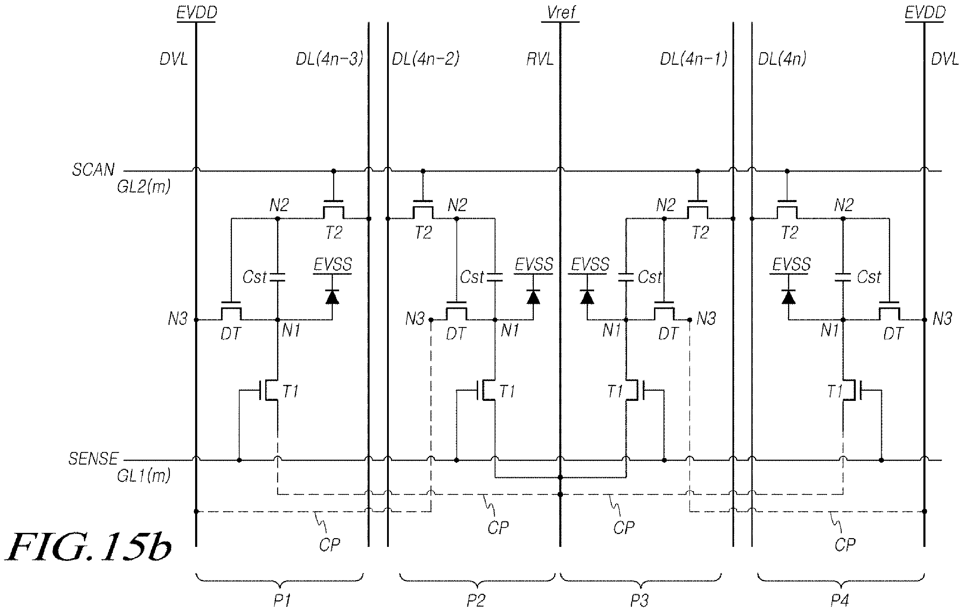

**FIGS. 15A** **and** **15B** are diagrams comparatively illustrating numerical apertures of a display device according to one embodiment of the present invention in which a shared node of first transistors of respective pixels is integrally configured with a reference voltage line RVL, and a display device in which a first transistor of each pixel is configured in each pixel.

In a display device according to one embodiment of the present invention illustrated in FIG. 15A, a shared node of the first transistor of each pixel is formed integrally with a reference voltage line RVL. Whereas, in a conventional display device illustrated in FIG. 15B, a first transistor for each pixel may be formed in each pixel.

In the conventional display device illustrated in FIG. 15B, one reference voltage line RVL is shared by a unit of four pixels in a 3T1C structure. At this time, a connection wiring for sharing the reference voltage line RVL in a circuit part of the four pixels is needed, which in turn leads to the reduction of a numerical aperture. In addition, since a design should be made in consideration of a process margin and repair margin of first transistors serving as respective sensing transistors, the practical numerical aperture is greatly reduced.

On the contrary, in the display device according to one embodiment of the present invention illustrated in FIG. 15A, the first transistors serving as the sensing transistors are positioned on the reference voltage line RVL, and the shared node of the first transistors serving as the respective sensing transistors is formed integrally with the reference voltage line RVL in order to solve the problem of the conventional display device (FIG. 15B). Thus, the increase of the numerical aperture may be maximized. A defect occurring due to the share of the reference voltage line RVL is equally divided into resistance components of respective pixels. The defect level can be alleviated as compared with the defect level of the conventional display device.

Accordingly, it may be understood that the display device according to one embodiment of the present invention illustrated in FIG. 15A has a display region (light emitting region) increased to further increase the numerical aperture as compared with that of the conventional display device illustrated in FIG. 15B. From this, further improvement of the numerical aperture can be expected when the resolution or area is increased.

As described above, according to the present invention, it is possible to provide an organic light emitting display device 10 having a simple and compact panel structure.

In addition, according to the present invention, it is possible to provide an organic light emitting display device 10 that may increase the numerical aperture, lengthen a lifespan of light emitting diodes, and reduce the incidence probability of defects.

When these features are applied to a high resolution and large area panel 11, a greater effect may be achieved.

While the present invention has been exemplarily described with reference to the accompanying drawings, it will be understood by a person skilled in the art that the present invention may be varied and modified in various forms within the scope of the appended claims.

On the contrary, in the display device according to one embodiment of the present invention illustrated in FIG. 15A, the first transistors serving as the sensing transistors are positioned on the reference voltage line RVL, and the shared node of the first transistors serving as the respective sensing transistors is formed integrally with the reference voltage line RVL in order to solve the problem of the conventional display device (FIG. 15B). Thus, the increase of the numerical aperture may be maximized. A defect occurring due to the share of the reference voltage line RVL is equally divided into resistance components of respective pixels. The defect level can be alleviated as compared with the defect level of the conventional display device.

Accordingly, it may be understood that the display device according to one embodiment of the present invention illustrated in FIG. 15A has a display region (light emitting region) increased to further increase the numerical aperture as compared with that of the conventional display device illustrated in FIG. 15B. From this, further improvement of the numerical aperture can be expected when the resolution or area is increased.

As described above, according to the present invention, it is possible to provide an organic light emitting display device 10 having a simple and compact panel structure.

In addition, according to the present invention, it is possible to provide an organic light emitting display device 10 that may increase the numerical aperture, lengthen a lifespan of light emitting diodes, and reduce the incidence probability of defects.

When these features are applied to a high resolution and large area panel 11, a greater effect may be effected.

While the present invention has been exemplarily described with reference to the accompanying drawings, it will be understood by a person skilled in the art that the present invention may be varied and modified in various forms within the scope of the appended claims.

## Claims

1. An organic light emitting display device (10) comprising:
a plurality of data lines (DL(1) ... DL(4N)) positioned in one direction;
a plurality of gate lines (GL(1) ... GL(M)) positioned in another direction intersecting with the plurality of data lines;
a plurality of reference voltage lines (RVL) positioned in the one direction, wherein the number of reference voltage lines is one fourth of the number of data lines,
a plurality of pixels (P1, P2, P3, P4) connected with the plurality of data lines (DL(1) ... DL(4N)) and the plurality of gate lines (GL(1) ... GL(M)),
wherein each of the plurality of pixels (P1, P2, P3, P4) includes: an organic light emitting diode (OLED), a driving transistor (DT) configured to drive the organic light emitting diode, a first transistor (T1) controlled by a first scan signal from the gate lines and connected between one of the reference voltage lines (RVL) and a first node (N1) of the driving transistor (DT), and a second transistor (T2) controlled by a second scan signal supplied from the gate lines and connected between one of the data lines and a second node (N2) of the driving transistor (DT),
wherein each reference voltage line (RVL) is positioned in the one direction and configured to supply a reference voltage (Vref) to a first pixel (P1) connected with a (4n-3)th data line, a second pixel (P2) connected with a (4n-2)th data line, a third pixel (P3) connected with a (4n-1)th data line, and a fourth pixel (P4) connected with a (4n)th data line, wherein n is a natural number of 1 or more,
wherein the first to fourth pixels are positioned adjacent to each other along the other direction,
wherein each first transistor (T11, T12, T13, T14) has a first node of one of drain and source electrode of the first transistor and a second node of the other of drain and source electrode of the first transistor, wherein the first nodes of the first transistors (T11, T12, T13, T14) of the first to fourth pixels (P1, P2, P3, P4) are configured as a shared node (Ns) formed integrally with the reference voltage line (RVL), and the second nodes (N11, N12, N13, N14) of the first transistors (T11, T12, T13, T14) of said first to fourth pixels (P1, P2, P3, P4) are configured as individual nodes (N1 1, N12, N13, N14), and each of said individual nodes (N11, N12, N13, N14) is connected with the first node (N1) of the driving transistor (DT) of the respective pixel (P1, P2, P3, P4);
the organic light emitting display device (10) further comprising a semiconductor layer (ACT) positioned between the shared node (Ns) and the four individual nodes (N11, N12, N13, N14), wherein the semiconductor layer (ACT) is one common layer between the shared node (Ns) and the four individual nodes (N11, N12, N13, N14),
wherein the four first transistors of the first to fourth pixels are controlled by a first scan signal supplied from a first gate line to one gate electrode which is positioned below or above the semiconductor layer, and wherein the gate electrode is integral with the first gate line or is connected with the first gate line.

2. The organic light emitting display device (10) of claim 1, wherein
the individual node (N11) of the first transistor (T11) included in the first pixel (P1) is connected through a connection pattern (CP) with the first node (N1) of the driving transistor (DT) included in the first pixel (P1);
the individual node (N12) of the first transistor (T12) included in the second pixel (P2) is connected directly with the first node (N1) of the driving transistor (DT) included in the second pixel (P2);
the individual node (N13) of the first transistor (T13) included in the third pixel (P3) is connected directly with the first node (N1) of the driving transistor (DT) included in the third pixel (P3), and
the individual node (N14) of the first transistor (T14) included in the fourth pixel (P4) is connected through a connection pattern (CP) with the first node (N1) of the driving transistor (DT) included in the fourth pixel (P4).

3. The organic light emitting display device (10) of claim 1 or 2, wherein the shared node (Ns) has a shape obtained by combining two or more of a "1" shape, a "-" shape, a "¬" shape, a "L" shape, a "⊏" shape, and partially rounded shapes thereof.

4. The organic light emitting display device (10) of claim 3, wherein the shared node (Ns) has a "+" shape, a "⊥" shape, or a " 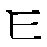 " shape.

5. The organic light emitting display device of any one of claims 1 to 4, wherein a distance between the shared node (Ns) and the individual node (N11, N12, N13, N14) of at least one of the four first transistors (T11, T12, T13, T14) is different from that of another one of the four first transistors (T11, T12, T13, T14).

6. The organic light emitting display device of any one of claims 1 to 4, wherein a pixel structure of the first pixel (P1) and a pixel structure of the fourth pixel (P4) are symmetric to each other with respect to the reference voltage line (RVL), and a pixel structure of the second pixel (P2) and a pixel structure of the third pixel (P3) are symmetric to each other with respect to the reference voltage line (RVL).

7. The organic light emitting display device (10) of any one of claims 1 to 6, further comprising a display panel, wherein the display panel comprises:
a data driver (12) configured to drive the plurality of data lines (DL(1) ... DL(4N)) positioned in the one direction;
a gate driver (13) configured to supply a first scan signal (SENSE) and a second signal (SCAN) through the plurality of gate lines (GL(1) ... GL(M)) which are positioned in the other direction intersecting with the data lines; and
a timing controller (14) configured to control a driving timing of the data driver and the gate driver.

8. The organic light emitting display device (10) of claim 7, further comprising:
a sensor (91) configured to sense a voltage of the first node (N1) of the driving transistor (DT).

9. The organic light emitting display device (10) of claim 8, wherein the sensor (91) comprises:
an analog-to-digital converter (912) configured to convert the sensed voltage into a digital value; and
a first switch (913) configured to perform switching such that one of a reference voltage supply node (9131), to which a reference voltage (Vref) is supplied, and a sensing node (9132) connected to the analog digital converter (912) is connected with the reference voltage line (RVL).

10. The organic light emitting display device (10) of claim 8 or 9, wherein a plurality of sensors (91) are provided, the number of the sensors (91) corresponding to the number of the data lines (DL(1) ... DL(4N)) or the number of the reference voltage lines (RVL).

11. The organic light emitting display device (10) of claim 9, wherein the timing controller (14) controls switching operations of:
a first switch (913) configured to perform switching between an ON position, in which the reference voltage line (RVL) is connected with the reference voltage supply node (9131), and an OFF position, in which the reference voltage line (RVL) is connected with the sensing node (9132), and
a second switch (914) configured to perform switching between an ON position, in which a data voltage output point (9141) of the data driver (12) is connected with a corresponding data line (DL), and an OFF position, in which the data line (DL) is disconnected from the voltage output point (9141) and floating.

12. The organic light emitting display device (10) of any one of claims 8 to 10, further comprising:
a compensator (93) configured to perform data conversion processing that compensates characteristic information of the driving transistor (DT) based on the sensed voltage; and
a memory (92) configured to store the sensed voltage or the characteristic information of the driving transistor (DT).

13. The organic light emitting display device (10) of claim 12, wherein the compensator (93) is included within the timing controller (14), within the data driver (12), or outside of the timing controller (14) and the data driver (12).

14. The organic light emitting display device (10) of claim 13, wherein,
if the compensator (93) is included within the timing controller (14), the compensator converts data supplied from the outside into compensation data based on the characteristic information of the driving transistor (DT), and supplies the compensation data to the data driver (12),
if the compensator (93) is included within the data driver (12), the compensator converts data supplied from the timing controller (14) into the compensation data based on the characteristic information of the driving transistor (DT), before or after converting the data supplied from the timing controller into analog data, and
if the compensator (93) is included outside of the timing controller (14) and the data driver (12), the compensator converts the data supplied from the timing controller into the compensation data based on the characteristic information of the driving transistor (DT) and supplies the compensation data to the data driver.

## Patentansprüche

1. Eine organische lichtemittierende Anzeige-Vorrichtung (10), aufweisend:
eine Vielzahl von Datenleitungen (DL(1)...DL(4N)), die in einer Richtung positioniert sind;
eine Vielzahl von Gate-Leitungen (GL(1)...GL(M)), die mit der Vielzahl von Datenleitungen kreuzend in einer anderen Richtung positioniert sind;
eine Vielzahl von Referenzspannungsleitungen (RVL), die in der einen Richtung positioniert sind, wobei die Anzahl von Referenzspannungsleitungen ein Viertel der Anzahl von Datenleitungen ist,
eine Vielzahl von Pixeln (P1, P2, P3, P4), die mit der Vielzahl von Datenleitungen (DL(1)...,DL(4N)) und der Vielzahl von Gate-Leitungen (GL(1)...GL(M)) verbunden sind,
wobei jedes der Vielzahl von Pixeln (P1, P2, P3, P4) enthält: eine organische lichtemittierende Diode (OLED), einen Treibertransistor (DT), der konfiguriert ist, die organische lichtemittierende Diode anzusteuern, einen ersten Transistor (T1), der durch ein erstes Scansignal von den Gate-Leitungen gesteuert wird und zwischen eine der Referenzspannungsleitungen (RVL) und einen ersten Knoten (N1) des Treibertransistors (DT) geschaltet ist, und einen zweiten Transistor (T2), der durch ein von den Gate-Leitungen geliefertes zweites Scansignal gesteuert wird und zwischen eine der Datenleitungen und einen zweiten Knoten (N2) des Treibertransistors (DT) geschaltet ist,
wobei jede Referenzspannungsleitung (RVL) in der einen Richtung positioniert ist und konfiguriert ist, eine Referenzspannung (Vref) an ein mit einer (4n-3)-ten Datenleitung verbundenes erstes Pixel (P1), ein mit einer (4n-2)-ten Datenleitung verbundenes zweites Pixel (P2), ein mit einer (4n-1)-ten Datenleitung verbundenes drittes Pixel (P3) und ein mit einer (4n)-ten Datenleitung verbundenes viertes Pixel (P4) zu liefern, wobei n eine natürliche Zahl von 1 oder mehr ist,
wobei das erste bis vierte Pixel zueinander benachbart entlang der anderen Richtung positioniert ist,
wobei jeder erste Transistor (T11, T12, T13, T14) einen ersten Knoten von einer der Drain- und Source-Elektrode des ersten Transistors und einen zweiten Knoten von der anderen der Drain- und Source-Elektrode des ersten Transistors hat, wobei die ersten Knoten der ersten Transistoren (T11, T12, T13, T14) des ersten bis vierten Pixels (P1, P2, P3, P4) als ein gemeinsam genutzter Knoten (Ns) konfiguriert sind, der integral mit der Referenzspannungsleitung (RVL) ausgebildet ist, und die zweiten Knoten (N11, N12, N13, N14) der ersten Transistoren (T11, T12, T13, T14) des besagten ersten bis vierten Pixels (P1, P2, P3, P4) als einzelne Knoten (N11, N12, N13, N14) konfiguriert sind und jeder der besagten einzelnen Knoten (N11, N12, N13, N14) mit dem ersten Knoten (N1) des Treibertransistors (DT) des entsprechenden Pixels (P1, P2, P3, P4) verbunden ist;
die organische lichtemittierende Anzeige-Vorrichtung (10) ferner eine Halbleiterschicht (ACT) aufweisend, die zwischen dem gemeinsam genutzten Knoten (Ns) und den vier einzelnen Knoten (N11, N12, N13, N14) positioniert ist, wobei die Halbleiterschicht (ACT) eine gemeinsame Schicht zwischen dem gemeinsam genutzten Knoten (Ns) und den vier einzelnen Knoten (N11, N12, N13, N14) ist,
wobei die vier ersten Transistoren des ersten bis vierten Pixels durch ein erstes Scansignal gesteuert werden, das von einer ersten Gate-Leitung an eine Gate-Elektrode geliefert wird, die unter oder über der Halbleiterschicht positioniert ist, und wobei die Gate-Elektrode integral mit der ersten Gate-Leitung ist oder mit der ersten Gate-Leitung verbunden ist.

2. Die organische lichtemittierende Anzeige-Vorrichtung (10) gemäß Anspruch 1, wobei
der einzelne Knoten (N11) des in dem ersten Pixel (P1) enthaltenen ersten Transistors (T11) durch eine Verbindungsstruktur (CP) mit dem ersten Knoten (N1) des in dem ersten Pixel (P1) enthaltenen Treibertransistors (DT) verbunden ist;
der einzelne Knoten (N12) des in dem zweiten Pixel (P2) enthaltenen ersten Transistors (T12) direkt mit dem ersten Knoten (N1) des in dem zweiten Pixel (P2) enthaltenen Treibertransistors (DT) verbunden ist;
der einzelne Knoten (N13) des in dem dritten Pixel (P3) enthaltenen ersten Transistors (T13) direkt mit dem ersten Knoten (N1) des in dem dritten Pixel (P3) enthaltenen Treibertransistors (DT) verbunden ist, und
der einzelne Knoten (N14) des in dem vierten Pixel (P4) enthaltenen ersten Transistors (T14) durch eine Verbindungsstruktur (CP) mit dem ersten Knoten (N1) des in dem vierten Pixel (P4) enthaltenen Treibertransistors (DT) verbunden ist.

3. Die organische lichtemittierende Anzeige-Vorrichtung (10) gemäß Anspruch 1 oder 2, wobei der gemeinsam genutzte Knoten (Ns) eine Form hat, die durch Kombinieren zweier oder mehrerer von einer "1"-Form, einer "-" -Form, einer "¬" -Form, einer "L" -Form, einer "⊏" -Form und teilweise abgerundeten Formen davon, erhalten wird.

4. Die organische lichtemittierende Anzeige-Vorrichtung (10) gemäß Anspruch 3, wobei der gemeinsam genutzte Knoten (Ns) eine "+" -Form, eine "⊥" -Form oder eine " 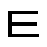 " -Form hat.

5. Die organische lichtemittierende Anzeige-Vorrichtung gemäß einem der Ansprüche 1 bis 4, wobei eine Distanz zwischen dem gemeinsam genutzten Knoten (Ns) und dem einzelnen Knoten (N11, N12, N13, N14) von mindestens einem der vier ersten Transistoren (T11, T12, T13, T14) anders ist als die von einem anderen der vier ersten Transistoren (T11, T12, T13, T14).

6. Die organische lichtemittierende Anzeige-Vorrichtung gemäß einem der Ansprüche 1 bis 4, wobei eine Pixel-Struktur des ersten Pixels (P1) und eine Pixel-Struktur des vierten Pixels (P4) bezüglich der Referenzspannungsleitung (RVL) symmetrisch zueinander sind und eine Pixel-Struktur des zweiten Pixels (P2) und eine Pixelstruktur des dritten Pixels (P3) bezüglich der Referenzspannungsleitung (RVL) symmetrisch zueinander sind.

7. Die organische lichtemittierende Anzeige-Vorrichtung (10) gemäß einem der Ansprüche 1 bis 6, ferner ein Anzeige-Panel aufweisend, wobei das Anzeige-Panel aufweist:
einen Datentreiber (12), der konfiguriert ist, die Vielzahl von Datenleitungen (DL(1)...DL(4N)) anzusteuern, die in der einen Richtung positioniert sind;
einen Gatetreiber (13), der konfiguriert ist, ein erstes Scansignal (SENSE) und ein zweites Scansignal (SCAN) durch die Vielzahl von Gateleitungen (GL(1)...GL(M)) zu liefern, die mit den Datenleitungen kreuzend in der anderen Richtung positioniert sind; und
eine Timing-Steuereinrichtung (14), die konfiguriert ist, ein Ansteuer-Timing des Datentreibers und des Gatetreibers zu steuern.

8. Die organische lichtemittierende Anzeige-Vorrichtung (10) gemäß Anspruch 7, ferner aufweisend:
einen Sensor (91), der konfiguriert ist, eine Spannung des ersten Knotens (N1) des Treibertransistors (DT) abzutasten.

9. Die organische lichtemittierende Anzeige-Vorrichtung (10) gemäß Anspruch 8, wobei der Sensor (91) aufweist:
einen Analog-Digital-Wandler (912), der konfiguriert ist, das abgetastete Signal in einen digitalen Wert zu wandeln, und
einen ersten Schalter (913), der konfiguriert ist, Schalten derart auszuführen, dass einer von einem Referenspannungslieferknoten (9131), an den eine Referenzspannung (Vref) geliefert wird, und einem Abtast-Knoten (9132), der mit dem Analog-Digital-Wandler (912) verbunden ist, mit der Referenzspannungsleitung (RVL) verbunden ist.

10. Die organische lichtemittierende Anzeige-Vorrichtung (10) gemäß Anspruch 8 oder 9, wobei eine Vielzahl von Sensoren (91) bereitgestellt sind, wobei die Anzahl der Sensoren (91) zu der Anzahl der Datenleitungen (DL(1)...DL(4N) oder der Anzahl der Referenzspannungsleitungen (RVL) korrespondiert.

11. Die organische lichtemittierende Anzeige-Vorrichtung (10) gemäß Anspruch 9, wobei die Zeitsteuereinrichtung (14) Schaltvorgänge steuert von:
einem ersten Schalter (913), der konfiguriert ist, Schalten zwischen einer AN-Position, in der die Referenzspannungsleitung (RVL) mit dem Referenzspannungslieferknoten (9131) verbunden ist, und einer AUS-Position, in der die Referenzspannungsleitung (RVL) mit dem Abtast-Knoten (9132) verbunden ist, auszuführen und
einem zweiten Schalter (914), der konfiguriert ist, Schalten zwischen einer AN-Position, in der ein Datenspannungsausgabepunkt (9141) des Datentreibers (12) mit einer korrespondierenden Datenleitung (DL) verbunden ist, und einer AUS-Position, in der die Datenleitung (DL) von dem Spannungsausgabepunkts (9141) getrennt und potentialfrei ist, auszuführen.

12. Die organische lichtemittierende Anzeige-Vorrichtung (10) gemäß einem der Ansprüche 8 bis 10, ferner aufweisend:
einen Kompensator (93), der konfiguriert ist, Datenumwandlungsverarbeitung auszuführen, das charakteristische Information des Treibertransistors (DT) auf Basis der abgetasteten Spannung kompensiert; und
einen Speicher (92), der konfiguriert ist, die abgetastete Spannung oder die charakteristische Information des Treibertransistors (DT) zu speichern.

13. Die organische lichtemittierende Anzeige-Vorrichtung (10) gemäß Anspruch 12, wobei der Kompensator (93) innerhalb der Zeitsteuereinrichtung (14), innerhalb des Datentreibers (12) oder außerhalb der Zeitsteuereinrichtung (14) und des Datentreibers (12) enthalten ist.

14. Die organische lichtemittierende Anzeige-Vorrichtung (10) gemäß Anspruch 13, wobei, wenn der Kompensator (93) innerhalb der Zeitsteuereinrichtung (14) enthalten ist, der Kompensator von außen gelieferte Daten auf Basis der charakteristischen Information des Treibertransistors (DTA) in Kompensationsdaten wandelt und die Kompensationsdaten an den Datentreiber (12) liefert,
wenn der Kompensator (93) innerhalb des Datentreibers (12) enthalten ist, der Kompensator von der Timing-Steuereinrichtung (14) gelieferte Daten auf Basis der charakteristischen Information des Treibertransistors (DTA) in die Kompensationsdaten wandelt, vor oder nach Umwandeln der von der Timing-Steuereinrichtung gelieferten Daten in analoge Daten, und
wenn der Kompensator (93) außerhalb der Timing-Steuereinrichtung (14) und des Datentreibers (12) enthalten ist, der Kompensator die von der Timing-Steuereinrichtung gelieferten Daten auf Basis der charakteristischen Information des Treibertransistors (DTA) in die Kompensationsdaten wandelt und die Kompensationsdaten an den Datentreiber liefert.

## Revendications

1. Dispositif d'affichage électroluminescent organique (10) comprenant :
une pluralité de lignes de données (DL(1), ..., DL(4N)) positionnée dans une direction;
une pluralité de lignes de grille (GL(1), ..., GL(M)) positionnée dans une autre direction croisant la pluralité de lignes de données ;
une pluralité de lignes de tension de référence (RVL) positionnée dans une direction, dans lequel le nombre de lignes de tension de référence est égal à un quart du nombre de lignes de données ;
une pluralité de pixels (P1, P2, P3, P4) connectée à la pluralité de lignes de données (DL(1), ..., DL(4N)) et à la pluralité de lignes de grille (GL(1), ..., GL(M)) ;
dans lequel chaque pixel de la pluralité de pixels (P1, P2, P3, P4) inclut : une diode électroluminescente organique (OLED), un transistor d'attaque (DT) configuré de manière à commander la diode électroluminescente organique, un premier transistor (T1) commandé par un premier signal de balayage provenant des lignes de grille et connecté entre l'une des lignes de tension de référence (RVL) et un premier noeud (N1) du transistor d'attaque (DT), et un second transistor (T2) commandé par un second signal de balayage fourni à partir des lignes de grille et connecté entre l'une des lignes de données et un second noeud (N2) du transistor d'attaque (DT) ;
dans lequel chaque ligne de tension de référence (RVL) est positionnée dans ladite une direction et est configurée de manière à fournir une tension de référence (Vref) à un premier pixel (P1) connecté à une (4n-3)ième ligne de données, à un deuxième pixel (P2) connecté à une (4n-2)ième ligne de données, à un troisième pixel (P3) connecté à une (4n-1)ième ligne de données, et à un quatrième pixel (P4) connecté à une (4n)ième ligne de données, dans lequel « n » correspond à un nombre naturel supérieur ou égal à « 1 »,
dans lequel les premier à quatrième pixels sont positionnés adjacents les uns aux autres le long de l'autre direction ;
dans lequel chaque premier transistor (T11, T12, T13, T14) présente un premier noeud de l'une parmi une électrode drain et une électrode source du premier transistor, et un second noeud de l'autre parmi l'électrode drain et l'électrode source du premier transistor, dans lequel les premiers noeuds des premiers transistors (T11, T12, T13, T14) des premier à quatrième pixels (P1, P2, P3, P4) sont configurés en tant qu'un noeud partagé (Ns) formé intégralement avec la ligne de tension de référence (RVL), et les seconds noeuds (N11, N12, N13, N14) des premiers transistors (T11, T12, T13, T14) desdits premier à quatrième pixels (P1, P2, P3, P4) sont configurés en tant que des noeuds individuels (N11, N12, N13, N14), et chacun desdits noeuds individuels (N11, N12, N13, N14) est connecté au premier noeud (N1) du transistor d'attaque (DT) du pixel respectif (P1, P2, P3, P4) ;
le dispositif d'affichage électroluminescent organique (10) comprenant en outre une couche semi-conductrice (ACT) positionnée entre le noeud partagé (Ns) et les quatre noeuds individuels (N11, N12, N13, N14), dans lequel la couche semi-conductrice (ACT) est une couche commune entre le noeud partagé (Ns) et les quatre noeuds individuels (N11, N12, N13, N14) ;
dans lequel les quatre premiers transistors des premier à quatrième pixels sont commandés par un premier signal de balayage fourni d'une première ligne de grille à une électrode grille qui est positionnée en dessous ou au-dessus de la couche semi-conductrice, et dans lequel l'électrode grille est solidaire de la première ligne de grille ou est connectée à la première ligne de grille.

2. Dispositif d'affichage électroluminescent organique (10) selon la revendication 1, dans lequel :
le noeud individuel (N11) du premier transistor (T11) inclus dans le premier pixel (P1) est connecté, à travers un motif de connexion (CP), au premier noeud (N1) du transistor d'attaque (DT) inclus dans le premier pixel (P1) ;
le noeud individuel (N12) du premier transistor (T12) inclus dans le deuxième pixel (P2) est connecté directement au premier noeud (N1) du transistor d'attaque (DT) inclus dans le deuxième pixel (P2) ;
le noeud individuel (N13) du premier transistor (T13) inclus dans le troisième pixel (P3) est connecté directement au premier noeud (N1) du transistor d'attaque (DT) inclus dans le troisième pixel (P3) ; et
le noeud individuel (N14) du premier transistor (T14) inclus dans le quatrième pixel (P4) est connecté, à travers un motif de connexion (CP), au premier noeud (N1) du transistor d'attaque (DT) inclus dans le quatrième pixel (P4).

3. Dispositif d'affichage électroluminescent organique (10) selon la revendication 1 ou 2, dans lequel le noeud partagé (Ns) présente une forme obtenue en combinant deux des formes suivantes ou plus : une forme « | », une forme « - », une forme « ¬ », une forme « L », une forme « ⊏ », et des formes connexes partiellement arrondies.

4. Dispositif d'affichage électroluminescent organique (10) selon la revendication 3, dans lequel le noeud partagé (Ns) présente une forme « + », une forme « ⊥ » ou une forme « 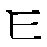 ».

5. Dispositif d'affichage électroluminescent organique selon l'une quelconque des revendications 1 à 4, dans lequel une distance entre le noeud partagé (Ns) et le noeud individuel (N11, N12, N13, N14) d'au moins l'un des quatre premiers transistors (T11, T12, T13, T14) est différente de celle d'un autre des quatre premiers transistors (T11, T12, T13, T14).

6. Dispositif d'affichage électroluminescent organique selon l'une quelconque des revendications 1 à 4, dans lequel une structure de pixel du premier pixel (P1) et une structure de pixel du quatrième pixel (P4) sont mutuellement symétriques relativement à la ligne de tension de référence (RVL), et une structure de pixel du deuxième pixel (P2) et une structure de pixel du troisième pixel (P3) sont mutuellement symétriques relativement à la ligne de tension de référence (RVL).

7. Dispositif d'affichage électroluminescent organique (10) selon l'une quelconque des revendications 1 à 6, comprenant en outre un panneau d'affichage, dans lequel le panneau d'affichage comprend :
un pilote de données (12) configuré de manière à piloter la pluralité de lignes de données (DL(1), ..., DL(4N)) positionnée dans une direction ;
un pilote de grille (13) configuré de manière à fournir un premier signal de balayage (SENSE) et un second signal (SCAN) à travers la pluralité de lignes de grille (GL(1), ..., GL(M)) qui est positionnée dans l'autre direction coupant les lignes de données ; et
un contrôleur de temporisation (14) configuré de manière à commander une synchronisation d'attaque du pilote de données et du pilote de grille.

8. Dispositif d'affichage électroluminescent organique (10) selon la revendication 7, comprenant en outre :
un capteur (91) configuré de manière à détecter une tension du premier noeud (N1) du transistor d'attaque (DT).

9. Dispositif d'affichage électroluminescent organique (10) selon la revendication 8, dans lequel le capteur (91) comprend :
un convertisseur analogique-numérique (912) configuré de manière à convertir la tension détectée en une valeur numérique ; et
un premier commutateur (913) configuré de manière à mettre en oeuvre une commutation de sorte que l'un parmi un noeud de fourniture de tension de référence (9131), auquel une tension de référence (Vref) est fournie, et un noeud de détection (9132) connecté au convertisseur analogique-numérique (912), est connecté à la ligne de tension de référence (RVL).

10. Dispositif d'affichage électroluminescent organique (10) selon la revendication 8 ou 9, dans lequel une pluralité de capteurs (91) est fournie, le nombre des capteurs (91) correspondant au nombre des lignes de données (DL(1), ..., DL(4N)) ou au nombre des lignes de tension de référence (RVL).

11. Dispositif d'affichage électroluminescent organique (10) selon la revendication 9, dans lequel le contrôleur de temporisation (14) commande des opérations de commutation des commutateurs suivants :
un premier commutateur (913) configuré de manière à mettre en oeuvre une commutation entre une position « MARCHE », dans laquelle la ligne de tension de référence (RVL) est connectée au noeud de fourniture de tension de référence (9131), et une position « ARRÊT », dans laquelle la ligne de tension de référence (RVL) est connectée au noeud de détection (9132) ; et
un second commutateur (914) configuré de manière à mettre en oeuvre une commutation entre une position « MARCHE », dans laquelle un point de sortie de tension de données (9141) du pilote de données (12) est connecté à une ligne de données correspondante (DL), et une position « ARRÊT », dans laquelle la ligne de données (DL) est déconnectée du point de sortie de tension (9141) et est flottante.

12. Dispositif d'affichage électroluminescent organique (10) selon l'une quelconque des revendications 8 à 10, comprenant en outre :
un compensateur (93) configuré de manière à mettre en oeuvre un traitement de conversion de données qui compense des informations de caractéristiques du transistor d'attaque (DT) sur la base de la tension détectée ; et
une mémoire (92) configurée de manière à stocker la tension détectée ou les informations de caractéristiques du transistor d'attaque (DT).

13. Dispositif d'affichage électroluminescent organique (10) selon la revendication 12, dans lequel le compensateur (93) est inclus dans le contrôleur de temporisation (14), dans le pilote de données (12) ou est situé en dehors du contrôleur de temporisation (14) et du pilote de données (12).

14. Dispositif d'affichage électroluminescent organique (10) selon la revendication 13, dans lequel,
si le compensateur (93) est inclus dans le contrôleur de temporisation (14), le compensateur convertit des données fournies depuis l'extérieur en des données de compensation, sur la base des informations de caractéristiques du transistor d'attaque (DT), et fournit les données de compensation au pilote de données (12) ;
si le compensateur (93) est inclus dans le pilote de données (12), le compensateur convertit des données, fournies à partir du contrôleur de temporisation (14), en des données de compensation, sur la base des informations de caractéristiques du transistor d'attaque (DT), avant ou après la conversion des données fournies à partir du contrôleur de temporisation en des données analogiques ; et
si le compensateur (93) est à l'extérieur du contrôleur de temporisation (14) et du pilote de données (12), le compensateur convertit les données fournies à partir du contrôleur de temporisation, en des données de compensation, sur la base des informations de caractéristiques du transistor d'attaque (DT), et fournit les données de compensation au pilote de données.
